# EUROPEAN PATENT APPLICATION

(11) **EP 4 462 982 A1**
(43) Date of publication of application: **13.11.2024**
(21) Application number: 24166077.8
(22) Date of filing: 25.03.2024
(51) Int. Cl.: H10K 59/12, H10K 59/122, H10K 59/80

(54) **DISPLAY DEVICE AND METHOD OF MANUFACTURING THE SAME**

(30) Priority: 10.05.2023 KR 20230060744
(71) Applicant: Samsung Display Co., Ltd., Yongin-si, Gyeonggi-do 17113 (KR)
(72) Inventor: PARK, Joon Yong, Yongin-si (KR); SHIN, Hyun Eok, Yongin-si (KR); YANG, Su Kyoung, Yongin-si (KR); LEE, Dong Min, Yongin-si (KR)
(74) Representative: Marks & Clerk LLP

(57) **Abstract**

A display device includes a first pixel electrode disposed in a first emission area on a substrate, an insulating layer covering edges of the first pixel electrode, a first light-emitting layer disposed on the first pixel electrode and the insulating layer, a first common electrode disposed on the first light-emitting layer, a first bank disposed on the insulating layer, the first bank surrounding the first emission area, a second bank disposed on the first bank, around the first emission area, the second bank including tips projected from sides of the first bank, and an etch control layer disposed on a top surface of the first common electrode, on the sides of the first bank, and on bottom surfaces of the tips of the second bank.

## Description

### BACKGROUND

### 1. Field

The disclosure relates to a display device and a method of manufacturing the same.

### 2. Description of the Related Art

As the information society is developed, the demand for display devices for displaying images is diversified. In an embodiment, display devices are being applied to various electronic devices such as smart phones, digital cameras, notebook computers, navigation systems, and smart televisions. Here, the display devices may be flat panel display devices such as a liquid crystal display ("LCD") device, a field emission display ("FED") device, or an organic light-emitting diode ("OLED") display device. Flat-panel light-emitting display devices, in particular, include light-emitting elements capable of allowing pixels to emit light, and may thus display images without the need of backlight units for providing light to display panels.

### SUMMARY

Features of the disclosure provide a display device capable of protecting the tips of a second bank during the etching of inorganic layers and a method of manufacturing the display device.

However, features of the disclosure are not restricted to those set forth herein. The above and other features of the disclosure will become more apparent to one of ordinary skill in the art to which the disclosure pertains by referencing the detailed description of the disclosure given below.

In an embodiment of the disclosure, a display device includes a substrate, a first pixel electrode disposed in a first emission area on the substrate, an insulating layer covering edges of the first pixel electrode, a first light-emitting layer disposed on the first pixel electrode and the insulating layer, a first common electrode disposed on the first light-emitting layer, a first bank disposed on the insulating layer and surrounding the first emission area, a second bank disposed on the first bank and around the first emission area, the second bank including tips projected from sides of the first bank, and an etch control layer disposed on a top surface of the first common electrode, on the sides of the first bank, and on bottom surfaces of the tips of the second bank.

In an embodiment, the display device may further include a first organic pattern disposed on the second bank, the first organic pattern surrounding the first emission area and including a same material as that of the first light-emitting layer, and a first electrode pattern disposed on the first organic pattern, the first electrode pattern including a same material as that of the first common electrode.

In an embodiment, the etch control layer may be disposed on a top surface and sides of the first electrode pattern.

In an embodiment, the display device may further include a capping layer disposed on the etch control layer, in the first emission area, and a first capping pattern disposed on a part of the etch control layer covering the first electrode pattern, the first capping pattern including a same material as that of the capping layer.

In an embodiment, the display device may further include a first inorganic layer disposed in the first emission area, on a top surface of the capping layer, on sides of the etch control layer, and on a top surface and sides of the first capping pattern.

In an embodiment, a vaporization temperature of the etch control layer for a fluorine (F)-based etching gas may be higher than a vaporization temperature of the first inorganic layer for the F-based etching gas.

In an embodiment, the etch control layer may include at least one of indium gallium zinc oxide ("IGZO"), indium zinc oxide ("IZO"), and gallium zinc oxide ("GZO").

In an embodiment, the display device may further include a second pixel electrode disposed in a second emission area, on the substrate, a second light-emitting layer disposed on the second pixel electrode, and a second common electrode disposed on the second light-emitting layer.

In an embodiment, the first bank may surround the second emission area, the second bank may be disposed on the first bank and around the second emission area, and the etch control layer may be disposed on a top surface of the second common electrode, on sides of part of the first bank surrounding the second emission area, and on bottom surfaces of the tips of the second bank around the second emission area.

In an embodiment, the display device may further include a second organic pattern surrounding the second emission area, on the second bank, the second organic pattern including a same material as that of the second light-emitting layer, and a second electrode pattern disposed on the second organic pattern, the second electrode pattern including a same material as that of the second common electrode.

In an embodiment, the etch control layer may be disposed on a top surface and sides of the second electrode pattern.

In an embodiment, the display device may further include a capping layer disposed on the etch control layer, in the second emission area, and a second capping pattern disposed on a part of the etch control layer covering the second electrode pattern, the second capping pattern including a same material as that of the capping layer.

In an embodiment, the display device may further include a second inorganic layer disposed in the second emission area, on a top surface of the capping layer, on sides of the etch control layer, and on a top surface and sides of the second capping pattern.

In an embodiment of the disclosure, a display device includes a first pixel electrode disposed in a first emission area on a substrate, an insulating layer covering edges of the first pixel electrode, a first light-emitting layer disposed on the first pixel electrode and the insulating layer, a first common electrode disposed on the first light-emitting layer, a first bank disposed on the insulating layer and surrounding the first emission area, a second bank disposed on the first bank and around the first emission area, the second bank including tips projected from sides of the first bank, an etch control layer disposed on a top surface of the first common electrode, on the sides of the first bank, and on bottom surfaces of the tips of the second bank, and a capping layer disposed on the etch control layer, in the first emission area.

In an embodiment, the display device may further include a first organic pattern disposed on the second bank, the first organic pattern surrounding the first emission area and including a same material as that of the first light-emitting layer, and a first electrode pattern disposed on the first organic pattern, the first electrode pattern including a same material as that of the first common electrode. The etch control layer may be disposed on a top surface and sides of the first electrode pattern.

In an embodiment of the disclosure, a method of manufacturing a display device includes forming first and second pixel electrodes on a substrate, sequentially stacking a sacrificial layer, an insulating layer, a first bank, and a second bank on the first and second pixel electrodes, forming tips of the second bank, the tips protruding from sides of the first bank, by etching the second bank and the first bank, exposing the first and second pixel electrodes by etching the insulating layer and the sacrificial layer, forming a first light-emitting layer on the first pixel electrode and forming a first organic pattern on the second bank, forming a first common electrode on the first light-emitting layer and forming a first electrode pattern on the first organic pattern, and forming an etch control layer disposed on a top surface of the first common electrode, on the sides of the first bank, on bottom surfaces of the tips of the second bank, and on a top surface and sides of the first electrode pattern.

In an embodiment, the method may further include forming a capping layer on a part of the etch control layer covering the first common electrode and forming a first capping pattern on a part of the etch control layer covering the first electrode pattern, and forming a first inorganic layer disposed on a top surface of the capping layer, on sides of the etch control layer, and on a top surface and sides of the first capping pattern.

In an embodiment, the method may further include forming photoresist disposed on the first inorganic layer, in a first emission area, and etching the first inorganic layer, the first capping pattern, and the capping layer using the photoresist as a mask.

In an embodiment, the etching the first inorganic layer, the first capping pattern, and the capping layer, may include preventing the tips of the second bank from being etched by the etch control layer.

In an embodiment, the etching the first inorganic layer, the first capping pattern, and the capping layer, may include performing a dry etching process using a fluorine (F)-based etching gas.

At least some of the above and other features of the invention are set out in the claims.

In the display device and the method of manufacturing the same in embodiments, as an etch control layer covering the bottom surfaces of tips, which are formed in banks, is provided, the tips may be prevented from being damaged or bent during the etching of inorganic layers. As a result, a plurality of light-emitting elements may be uniformed formed, and the reliability of a display device may be improved.

It should be noted that the effects of the disclosure are not limited to those described above, and other effects of the disclosure will be apparent from the following description.

### BRIEF DESCRIPTION OF THE DRAWINGS

The above and other features and features of the disclosure will become more apparent by describing in detail embodiments thereof with reference to the attached drawings, in which:
FIG. 1 is a perspective view of an embodiment of a display device according to the disclosure;
FIG. 2 is a cross-sectional view of the display device of FIG. 1;
FIG. 3 is a plan view illustrating a display unit of the display device of FIG. 1;
FIG. 4 is a cross-sectional view illustrating part of the display device of FIG. 1;
FIG. 5 is an enlarged cross-sectional view of an area A1 of FIG. 4; and
FIGS. 6 through 15 are cross-sectional views illustrating an embodiment of a method of manufacturing a display device according to the disclosure.

### DETAILED DESCRIPTION

In the following description, for the purposes of explanation, numerous specific details are set forth in order to provide a thorough understanding of various embodiments or implementations of the disclosure. As used herein "embodiments" and "implementations" are interchangeable words that are non-limiting examples of devices or methods employing one or more of the disclosure disclosed herein. It is apparent, however, that various embodiments may be practiced without these specific details or with one or more equivalent arrangements. In other instances, structures and devices are shown in block diagram form in order to avoid unnecessarily obscuring various embodiments. Further, various embodiments may be different, but do not have to be exclusive nor limit the disclosure. For example, specific shapes, configurations, and characteristics of an embodiment may be used or implemented in other embodiments without departing from the disclosure.

Unless otherwise specified, the illustrated embodiments are to be understood as providing features of varying detail of some ways in which the disclosure may be implemented in practice. Therefore, unless otherwise specified, the features, components, modules, layers, films, panels, regions, and/or features, etc. (hereinafter individually or collectively referred to as "elements"), of the various embodiments may be otherwise combined, separated, interchanged, and/or rearranged without departing from the disclosure.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements.

Further, the X-axis, the Y-axis, and the Z-axis are not limited to three axes of a rectangular coordinate system, and thus the X-, Y-, and Z- axes, and may be interpreted in a broader sense. For example, the X-axis, the Y-axis, and the Z-axis may be perpendicular to one another, or may represent different directions that are not perpendicular to one another.

For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, ZZ, or the like. As used herein, the term "and/or" includes any and all combinations of one or more of the associated listed items.

Although the terms "first," "second," and the like may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein should be interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art. The term "about" can mean within one or more standard deviations, or within ± 30%, 20%, 10%, 5% of the stated value, for example.

Various embodiments are described herein with reference to cross-sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature, and the shapes of these regions may not reflect actual shapes of regions of a device and, as such, are not necessarily intended to be limiting.

As customary in the field, some embodiments are described and illustrated in the accompanying drawings in terms of functional blocks, units, parts, and/or modules. Those skilled in the art will appreciate that these blocks, units, parts, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, parts, and/or modules being implemented by microprocessors or other similar hardware, they may be programmed and controlled using software (e.g., microcode) to perform various functions discussed herein and may optionally be driven by firmware and/or software. It is also contemplated that each block, unit, part, and/or module may be implemented by dedicated hardware, or as a combination of dedicated hardware to perform some functions and a processor (e.g., one or more programmed microprocessors and associated circuitry) to perform other functions. Also, each block, unit, part, and/or module of some embodiments may be physically separated into two or more interacting and discrete blocks, units, parts, and/or modules without departing from the scope of the disclosure. Further, the blocks, units, parts, and/or modules of some embodiments may be physically combined into more complex blocks, units, parts, and/or modules without departing from the scope of the disclosure.

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

Hereinafter, detailed embodiments of the disclosure is described with reference to the accompanying drawings.

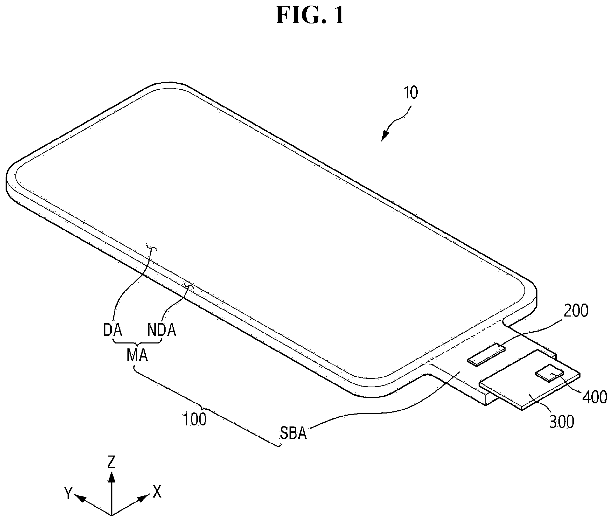

FIG. 1 is a perspective view of a display device according to the disclosure.

Referring to FIG. 1, a display device 10 is applicable to a portable electronic device such as a mobile phone, a smartphone, a tablet personal computer ("PC"), a mobile communication terminal, an electronic notepad, an electronic book ("e-book") reader, a portable multimedia player ("PMP"), a navigation device, or an ultra-mobile PC ("UMPC"). In an embodiment, the display device 10 may be applied as the display unit of a television ("TV"), a notebook computer, a monitor, a billboard, or an Internet-of-Things ("IoT") device, for example. In another embodiment, the display device 10 may be applied to a wearable device such as a smartwatch, a watchphone, a glasses display, or a head-mounted display ("HMD").

The display device 10 may have a rectangle-like shape in a plan view. In an embodiment, the display device 10 may have a rectangle-like shape with short sides in an X-axis direction and long sides in a Y-axis direction in a plan view, for example. The corners at which the short sides and the long sides of the display device 10 meet may be rounded or right-angled. However, the planar shape of the display device 10 is not particularly limited, and the display device 10 may be formed in various other shapes, such as another polygonal shape, a circular shape, or an elliptical shape.

The display device 10 may include a display panel 100, a display driving unit 200, a circuit board 300, and a touch driving unit 400.

The display panel 100 may include a main area MA and a subarea SBA.

The main area MA may include a display area DA, which includes pixels for displaying an image, and a non-display area NDA, which is disposed around the display area DA. The display area DA may emit light through a plurality of emission areas or openings. In an embodiment, the display panel 100 may include pixel circuits including switching elements, a pixel-defining film defining the emission areas or the openings, and self-light-emitting elements, for example.

In an embodiment, the self-light-emitting elements may include organic light-emitting diodes ("OLEDs"), quantum-dot light-emitting diodes ("LEDs") including a quantum-dot light-emitting layer, inorganic LEDs including an inorganic semiconductor, and/or micro-LEDs, for example, but the disclosure is not limited thereto.

The non-display area NDA may be on the outside of the display area DA. The non-display area NDA may be defined as an edge part of the main area MA. The non-display area NDA may include a gate driving unit (not illustrated) providing gate signals to gate lines and fan-out lines (not illustrated) connecting the display driving unit 200 and the display area DA.

The subarea SBA may extend from one side of the main area MA. The subarea SBA may include a flexible material that is bendable, foldable, or rollable. In an embodiment, in a case where the subarea SBA is bendable, the subarea SBA may be bent to overlap with the main area MA in a thickness direction (or a Z-axis direction), for example. The subarea SBA may include the display driving unit 200 and a pad unit, which is connected to the circuit board 300. In some embodiments, the subarea SBA may not be provided, and the display driving unit 200 and the pad unit may be disposed in the non-display area NDA.

The display driving unit 200 may output signals and voltages for driving the display panel 100. The display driving unit 200 may provide data voltages to data lines. The display driving unit 200 may provide power supply voltages to power lines and may provide gate control signals to the gate driving unit. The display driving unit 200 may be formed as an integrated circuit ("IC") and may be disposed (e.g., mounted) on the display panel 100 in a chip-on-glass ("COG") or chip-on-plastic ("COP") manner or via ultrasonic bonding. In an embodiment, the display driving unit 200 may be disposed in the subarea SBA and may overlap with the main area MA in the thickness direction (or the Z-axis direction) when the subarea SBA is bent, for example. In another embodiment, the display driving unit 200 may be disposed (e.g., mounted) on the circuit board 300.

The circuit board 300 may be attached to the pad unit of the display panel 100 via an anisotropic conductive film ("ACF"). Lead lines of the circuit board 300 may be electrically connected to the pad unit of the display panel 100. The circuit board 300 may be a printed circuit board ("PCB"), a flexible PCB ("FPCB"), or a flexible film such as a chip-on-film ("COF").

The touch driving unit 400 may be disposed (e.g., mounted) on the circuit board 300. The touch driving unit 400 may be electrically connected to a touch sensing unit of the display panel 100. The touch driving unit 400 may provide a touch driving signal to a plurality of touch electrodes of the touch sensing unit and may sense capacitance variations between the touch electrodes. In an embodiment, the touch driving signal may be a pulse signal having a predetermined frequency, for example. The touch driving unit 400 may determine the presence of input based on the capacitance variations between the touch electrodes and may calculate the coordinates of the input. The touch driving unit 400 may be formed as an IC.

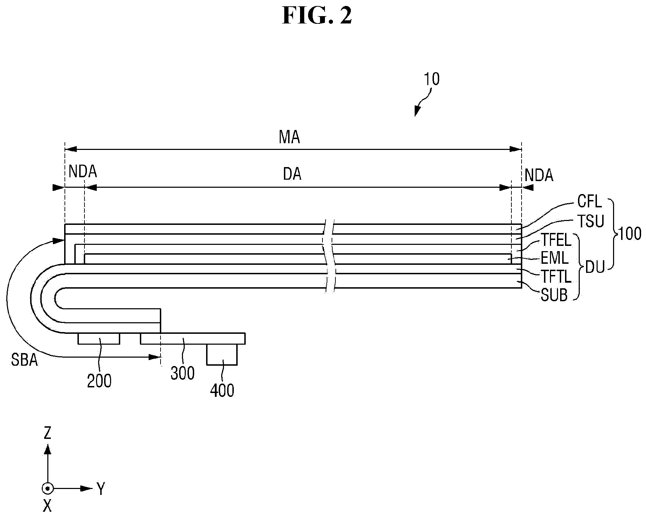

FIG. 2 is a cross-sectional view of the display device of FIG. 1.

Referring to FIG. 2, the display panel 100 may include a display unit DU, a touch sensing unit TSU, and a color filter layer CFL. The display unit DU may include a substrate SUB, a thin-film transistor ("TFT") layer TFTL, a light-emitting element layer EML, and an encapsulation layer TFEL.

The substrate SUB may be a base substrate or a base member. The substrate SUB may be a flexible substrate that is bendable, foldable, or rollable. In an embodiment, the substrate SUB may include a polymer resin such as polyimide ("PI"), for example, but the disclosure is not limited thereto. In another embodiment, the substrate SUB may include a glass material or a metal material.

The TFT layer TFTL may be disposed on the substrate SUB. The TFT layer TFTL may include a plurality of TFTs that form the pixel circuitry of pixels. The TFT layer TFTL may further include gate lines, data lines, power lines, gate control lines, and fan-out lines connecting the display driving unit 200 and the data lines, and lead lines connecting the display driving unit 200 and the pad unit. The TFTs may include semiconductor regions, source electrodes, drain electrodes, and gate electrodes. In an embodiment, in a case where the gate driving unit is formed on one side of the non-display area NDA of the display panel 100, the gate driving unit may include TFTs, for example.

The TFT layer TFTL may be disposed in the display area DA, the non-display area NDA, and the subarea SBA. The TFTs, the gate lines, the data lines, and the power lines of the TFT layer TFTL may be disposed in the display area DA. The gate control lines and the fan-out lines of the TFT layer TFTL may be disposed in the non-display area NDA. The lead lines of the TFT layer TFTL may be disposed in the subarea SBA.

The light-emitting element layer EML may be disposed on the TFT layer TFTL. The light-emitting element layer EML may include a plurality of light-emitting elements, in which pixel electrodes, light-emitting layers, and common electrodes are sequentially stacked to emit light, and a pixel-defining film, which defines the pixels. The light-emitting elements of the light-emitting element layer EML may be disposed in the display area DA.

In an embodiment, the light-emitting layers may be organic light-emitting layers including an organic material, for example. The light-emitting layers may include hole transport layers, organic light-emitting layers, and electron transport layers. As the pixel electrodes receive a predetermined voltage through the TFTs of the TFT layer TFTL and the common electrodes receive a cathode voltage, holes may move to the organic light-emitting layers through the hole transport layers, electrons may move to the organic light-emitting layers through the electron transport layers, and the holes and the electrons may combine together in the organic light-emitting layers, thereby emitting light. In an embodiment, the pixel electrodes and the common electrodes may be anodes and cathodes, respectively, for example, but the disclosure is not limited thereto.

In another embodiment, the light-emitting elements may be quantum-dot LEDs including quantum-dot light-emitting layers, inorganic LEDs including an inorganic semiconductor, or micro-LEDs.

The encapsulation layer TFEL may cover the top surface and sides of the light-emitting element layer EML and may protect the light-emitting element layer EML. The encapsulation layer TFEL may include at least one inorganic film and at least one organic film for encapsulating the light-emitting element layer EML.

The touch sensing unit TSU may be disposed on the encapsulation layer TFEL. The touch sensing unit TSU may include a plurality of touch electrodes for detecting touch input from a user in a capacitive manner and touch lines for connecting the touch electrodes and the touch driving unit 400. In an embodiment, the touch sensing unit TSU may sense touch input from the user in a mutual capacitance manner or in a self-capacitance manner.

In another embodiment, the touch sensing unit TSU may be disposed on a separate substrate, which is disposed on the display unit DU. In this example, the separate substrate may be an encapsulation substrate for the display unit DU.

The touch electrodes of the touch sensing unit TSU may be disposed in a touch sensor area overlapping with the display area DA. The touch lines of the touch sensing unit TSU may be disposed in a touch peripheral area overlapping with the non-display area NDA.

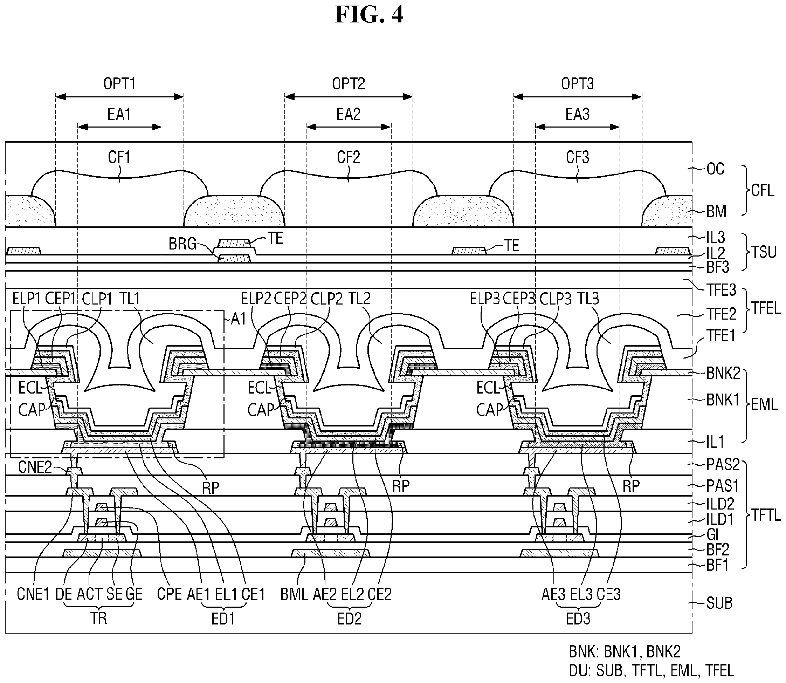

The color filter layer CFL may be disposed on the touch sensing unit TSU. The color filter layer CFL may include the color filters (CF1, CF2, and CF3 in Figure 4), which correspond to their respective emission areas. The color filters (CF1, CF2, and CF3 in Figure 4) may selectively transmit light of a particular wavelength therethrough and may block or absorb light of other wavelengths. The color filters (CF1, CF2, and CF3 in Figure 4) may reduce reflected light of external light by absorbing some of the external light. Accordingly, the color filters (CF1, CF2, and CF3 in Figure 4) may prevent color distortion that may be caused by the external light.

As the color filer layer CFL is disposed directly on the touch sensing unit TSU, the display device 10 may not need a separate substrate for the color filter layer CFL. Thus, the thickness of the display device 10 may be reduced.

The subarea SBA of the display panel 100 may extend from a side of the main area MA. The subarea SBA may include a flexible material that is bendable, foldable, or rollable. In an embodiment, when the subarea SBA is bent down, the subarea SBA may overlap with the main area MA in the thickness direction (or the Z-axis direction), for example. The subarea SBA may include a display driving unit 200 and a pad unit, which is electrically connected to a circuit board 300.

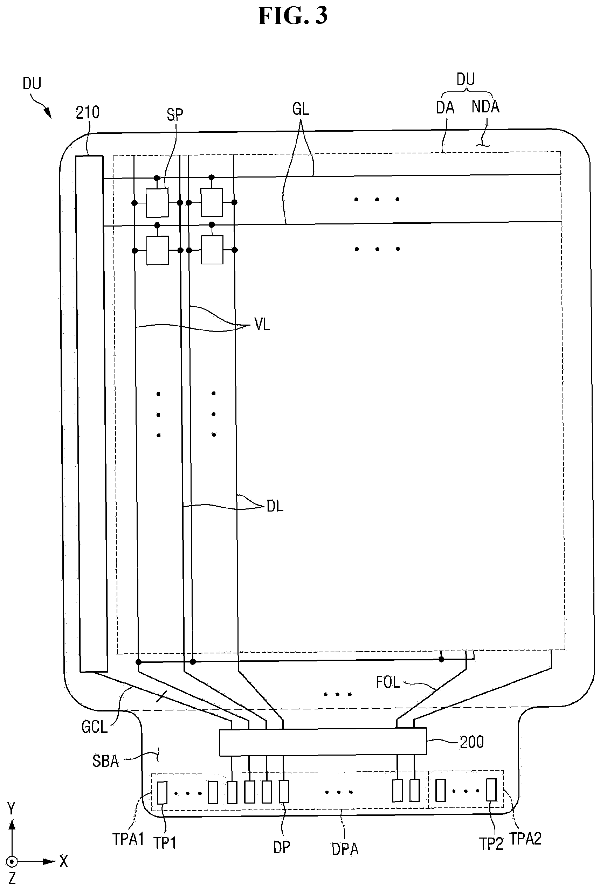

FIG. 3 is a plan view illustrating the display unit of the display device of FIG. 1.

Referring to FIG. 3, the display unit DU may include the display area DA and the non-display area NDA.

The display area DA, which is an area displaying an image, may be defined as a central area of the display panel 100. The display area DA may include a plurality of pixels SP, a plurality of gate lines GL, a plurality of data lines DL, and a plurality of power lines VL. The pixels SP may be defined as minimal units for emitting light.

The gate lines GL may provide gate signals received from a gate driving unit 210 to the pixels SP. The gate lines GL may extend in the X-axis direction and may be spaced apart from one another in the Y-axis direction, which intersects the X-axis direction.

The data lines DL may provide data voltages received from the display driving unit 200 to the pixels SP. The data lines DL may extend in the Y-axis direction and may be spaced apart from one another in the X-axis direction.

The power lines VL may provide the power supply voltages received from the display driving unit 200 to the pixels SP. Here, the power supply voltages include at least one of a driving voltage, an initialization voltage, a reference voltage, a bias voltage, and a relatively low-potential voltage. The power lines VL may extend in the Y-axis direction and may be spaced apart from one another in the X-axis direction.

The non-display area NDA may surround the display area DA. The non-display area NDA may include the gate driving unit 210, fan-out lines FOL, and gate control lines GCL. The gate driving unit 210 may generate a plurality of gate signals based on the gate control signals and may sequentially provide the gate signals to the gate lines GL in a predefined order.

The fan-out lines FOL may extend from the display driving unit 200 to the display area DA. The fan-out lines FOL may provide data voltages received from the display driving unit 200 to the data lines DL.

The gate control lines GCL may extend from the display driving unit 200 to the gate driving unit 210. The gate control lines GCL may provide gate control signals received from the display driving unit 200 to the gate driving unit 210.

The subarea SBA may include the display driving unit 200, a display pad area DPA, and first and second touch areas TPA1 and TPA2.

The display driving unit 200 may output signals and voltages for driving the display panel 100 to the fan-out lines FOL. The display driving unit 200 may provide data voltages to the data lines DL through the fan-out lines FOL. The data voltages may be provided to the pixels SP and may determine the luminance of the pixels SP. The display driving unit 200 may provide gate control signals to the gate driving unit 210 through the gate control lines GCL.

The display pad area DPA, the first touch pad area TPA1, and the second touch pad area TPA2 may be disposed on an edge of the subarea SBA. The display pad area DPA, the first touch pad area TPA1, and the second touch pad area TPA2 may be electrically connected to the circuit board 300 via a relatively low-resistance, relatively high-reliability material such as an anisotropic conductive film ("ACF") or a self-assembly anisotropic conductive paste ("SAP").

The display pad area DPA may include a plurality of display pads DP. The display pads DP may be electrically connected to a graphics system via the circuit board 300. The display pads DP may be connected to the circuit board 300 and may thus receive digital video data and provide the digital video data to the display driving unit 200.

The first touch pad area TPA1 may be disposed on one side of the display pad area DPA and may include a plurality of first touch pads TP1. The first touch pads TP1 may be electrically connected to the touch driving unit 400, which is disposed on the circuit board 300. The first touch pads TP1 may provide touch driving signals to a plurality of driving electrodes via a plurality of driving lines.

The second touch pad area TPA2 may be disposed on the other side of the display pad area DPA and may include a plurality of second touch pads TP2. The second touch pads TP2 may be electrically connected to the touch driving unit 400, which is disposed on the circuit board 300. The touch driving unit 400 may receive touch sensing signals via a plurality of sensing lines, which are connected to the second touch pads TP2, and may sense changes in the mutual capacitances between the driving electrodes and the sensing electrodes.

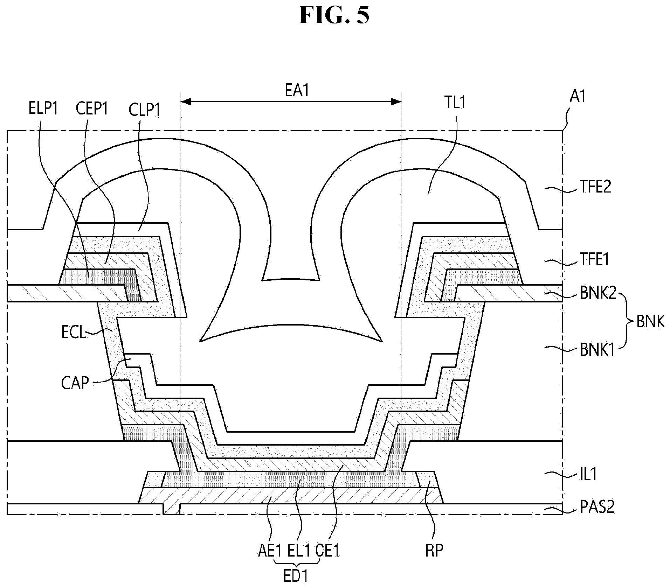

FIG. 4 is a cross-sectional view illustrating part of the display device of FIG. 1, and FIG. 5 is an enlarged cross-sectional view of an area A1 of FIG. 4.

Referring to FIGS. 4 and 5, the display panel 100 may include the display unit DU, the touch sensing unit TSU, and the color filter layer CFL. The display unit DU may include the substrate SUB, the TFT layer TFTL, the light-emitting element layer EML, and the encapsulation layer TFEL.

The substrate SUB may be a base substrate or a base member. The substrate SUB may be a flexible substrate that is bendable, foldable, or rollable. In an embodiment, the substrate SUB may include a polymer resin such as PI, for example, but the disclosure is not limited thereto. In another embodiment, the substrate SUB may include a glass or metal material.

The TFT layer TFTL may include a first buffer layer BF1, a light-blocking layer BML, a second buffer layer BF2, TFTs TR, a gate insulating layer GI, a first inter-insulating layer ILD1, capacitor electrodes CPE, a second inter-insulating layer ILD2, first connection electrodes CNE1, a first passivation layer PAS1, second connection electrodes CNE2, and a second passivation layer PAS2.

The first buffer layer BF1 may be disposed on the substrate SUB. The first buffer layer BF1 may include an inorganic film capable of preventing the infiltration of the air or moisture. In an embodiment, the first buffer layer BF1 may include a plurality of inorganic films that are alternately stacked, for example.

The light-blocking layer BML may be disposed on the first buffer layer BF1. In an embodiment, the light-blocking layer BML may be formed as a single layer or a multilayer including molybdenum (Mo), aluminium (Al), chromium (Cr), gold (Au), titanium (Ti), nickel (Ni), neodymium (Nd), copper (Cu), or any alloys thereof, for example, but the disclosure is not limited thereto. In another embodiment, the light-blocking layer BML may be an organic film including a black pigment.

The second buffer layer BF2 may be disposed on the first buffer layer BF1 and the light-blocking layer BML. The second buffer layer BF2 may include an inorganic film capable of preventing the infiltration of the air or moisture. In an embodiment, the second buffer layer BF2 may include a plurality of inorganic films that are alternately stacked, for example.

The TFTs TR may be disposed on the second buffer layer BF2 and may form the pixel circuitry of a plurality of pixels. In an embodiment, the TFTs TR may be driving transistors or switching transistors, for example. The TFTs TR may include semiconductor regions ACT, source electrodes SE, drain electrodes DE, and gate electrodes GE. In an embodiment, the source electrodes SE and the drain electrodes DE may be switched with each other based on a type of the TFT TR.

The semiconductor regions ACT, the source electrodes SE, and the drain electrodes DE may be disposed on the second buffer layer BF2. The semiconductor regions ACT, the source electrodes SE, and the drain electrodes DE may overlap with the light-blocking layer BML in the thickness direction. The semiconductor regions ACT may overlap with the gate electrodes GE in the thickness direction and may be insulated from the gate electrodes GE by the gate insulating layer GI. The source electrodes SE and the drain electrodes DE may be obtained by turning the material of the semiconductor regions ACT into conductors.

The gate electrodes GE may be disposed on the gate insulating layer GI. The gate electrodes GE may overlap with the semiconductor regions ACT with the gate insulating layer GI interposed therebetween.

The gate insulating layer GI may be disposed on the semiconductor regions ACT, the source electrodes SE, the drain electrodes DE, and the second buffer layer BF2. The gate insulating layer GI may insulate the semiconductor regions ACT and the gate electrodes GE.

A first inter-insulating layer ILD1 may be disposed on the gate electrodes GE and the gate insulating layer GI. The first inter-insulating layer ILD1 may insulate the gate electrodes GE and the capacitor electrodes CPE.

The capacitor electrodes CPE may be disposed on the first inter-insulating layer ILD1. The capacitor electrodes CPE may overlap with the gate electrodes GE in the thickness direction. The capacitor electrodes CPE and the gate electrodes GE may form capacitors.

The second inter-insulating layer ILD2 may be disposed on the capacitor electrodes CPE and the first inter-insulating layer ILD1. The second inter-insulating layer ILD2 may insulate the capacitor electrodes CPE and the first connection electrodes CNE1.

The first connection electrodes CNE1 may be disposed on the second inter-insulating layer ILD2. The first connection electrodes CNE1 may electrically connect the drain electrodes DE of the TFTs TR and the second connection electrodes CNE2. The first connection electrodes CNE1 may be inserted in the contact holes of each of the second inter-insulating layer ILD2, the first inter-insulating layer ILD1, and the gate insulating layer GI and may thus contact the drain electrodes DE of the TFTs TR.

The first passivation layer PAS1 may be disposed on the first connection electrodes CNE1 and the second inter-insulating layer ILD2. The first passivation layer PAS 1 may protect the TFTs TR. The first passivation layer PAS1 may insulate the first connection electrodes CNE1 and the second connection electrodes CNE2.

The second connection electrodes CNE2 may be disposed on the first passivation layer PAS 1. The second connection electrodes CNE2 may electrically connect the first connection electrodes CNE1 and a first pixel electrode AE1 of a first light-emitting element ED1. The second connection electrodes CNE2 may be inserted in the contact holes of the first passivation layer PAS1 and may thus contact the first connection electrodes CNE1.

The second passivation layer PAS2 may be disposed on the second connection electrodes CNE2 and the first passivation layer PAS 1. The second passivation layer PAS2 may insulate the second connection electrodes CNE2 and the first pixel electrode AE1.

In an embodiment, the substrate SUB and the TFT layer TFTL may be incorporated into a silicon (Si) wafer, for example, but the disclosure is not limited thereto. In this example, the light-emitting element layer EML may be formed on the Si wafer, and as the display device 10 includes the Si wafer, an image with an ultrahigh resolution may be realized.

The light-emitting element layer EML may be disposed on the TFT layer TFTL. The light-emitting element layer EML may include the first, second, and third light-emitting elements ED1, ED2, and ED3, residual patterns RP, a first insulating layer IL1, an etch control layer ECL, a capping layer CAP, banks BNK, first, second, and third organic patterns ELP1, ELP2, and ELP3, first, second, and third electrode patterns CEP1, CEP2, and CEP3, first, second, and third capping patterns CLP1, CLP2, and CLP3, and first, second, and third inorganic layers TL1, TL2, and TL3.

The display device 10 may include a plurality of pixels, which are arranged in multiple rows and multiple columns. Each of the pixels may include first, second, and third emission areas EA1, EA2, and EA3, which are defined by the banks BNK or a pixel-defining film, and may emit light having a predetermined peak wavelength through the first, second, and third emission areas EA1, EA2, and EA3. The first, second, and third emission areas EA1, EA2, and EA3 may be areas that output light generated by the first, second, and third light-emitting elements ED1, ED2, and ED3 to the outside of the display device 10.

The first, second, and third emission areas EA1, EA2, and EA3 may emit light having a predetermined peak wavelength to the outside of the display device 10. The first emission area EA1 may emit first-color light, the second emission area EA2 may emit second-color light, and the third emission area EA3 may emit third-color light. In an embodiment, the first-color light may be red light having a peak wavelength of about 610 nanometers (nm) to about 650 nm, the second-color light may be green light having a peak wavelength of about 510 nm to about 550 nm, and the third-color light may be blue light having a peak wavelength of about 440 nm to about 480 nm, for example. However, the disclosure is not limited to this example.

In an embodiment, the third emission area EA3 may be larger in size than the first emission area EA1, and the first emission area EA1 may be larger in size than the second emission area EA2, for example. However, the disclosure is not limited to this example. In another embodiment, the first, second, and third emission areas EA1, EA2, and EA3 may have substantially the same size as each other.

The first light-emitting element ED1 may be disposed in the first emission area EA1, on the TFT layer TFTL. The first light-emitting element ED1 may include the first pixel electrode AE1, a first light-emitting layer EL1, and a first common electrode CE1. The second light-emitting element ED2 may be disposed in the second emission area EA2, on the TFT layer TFTL. The second light-emitting element ED2 may include a second pixel electrode AE2, a second light-emitting layer EL2, and a second common electrode CE2. The third light-emitting element ED3 may be disposed in the third emission area EA3, on the TFT layer TFTL. The third light-emitting element ED3 may include a third pixel electrode AE3, a third light-emitting layer EL3, and a third common electrode CE3.

The first, second, and third pixel electrodes AE1, AE2, and AE3 may be disposed on the second passivation layer PAS2. The first, second, and third pixel electrodes AE1, AE2, and AE3 may be connected to the drain electrodes DE of the TFTs TR through the first connection electrodes CNE1 and the second connection electrodes CNE2. The first, second, and third pixel electrodes AE1, AE2, and AE3 may be insulated from one another by the first insulating layer IL1. In an embodiment, the first, second, and third pixel electrodes AE1, AE2, and AE3 may include at least one of Ag, Cu, Al, Ni, and lanthanum (La), for example. In another embodiment, the first, second, and third pixel electrodes AE1, AE2, and AE3 may include a material such as indium tin oxide ("ITO"), indium zinc oxide ("IZO"), or indium tin zinc oxide ("ITZO"). In yet another example, the first, second, and third pixel electrodes AE1, AE2, and AE3 may have a stack structure such as ITO/Ag/ITO/, ITO/Ag/IZO, or ITO/Ag/ITZO/IZO.

The first insulating layer IL1 may be disposed on the second passivation layer PAS2 and the residual patterns RP. The first insulating layer IL1 may cover the edges of each of the first, second, and third pixel electrodes AE1, AE2, and AE3 and the residual patterns RP and may expose parts of the top surfaces of the first, second, and third pixel electrodes AE1, AE2, and AE3. In an embodiment, the first insulating layer IL1 may expose the first pixel electrode AE1, in the first emission area EA1, and the first light-emitting layer EL1 may be disposed directly on the first pixel electrode AE1, for example. The first insulating layer IL1 may include an inorganic insulating material. The first insulating layer IL1 may include at least one of a silicon nitride layer, a silicon oxynitride layer, a silicon oxide layer, a titanium oxide layer, an aluminium oxide layer, and an amorphous silicon layer, but the disclosure is not limited thereto.

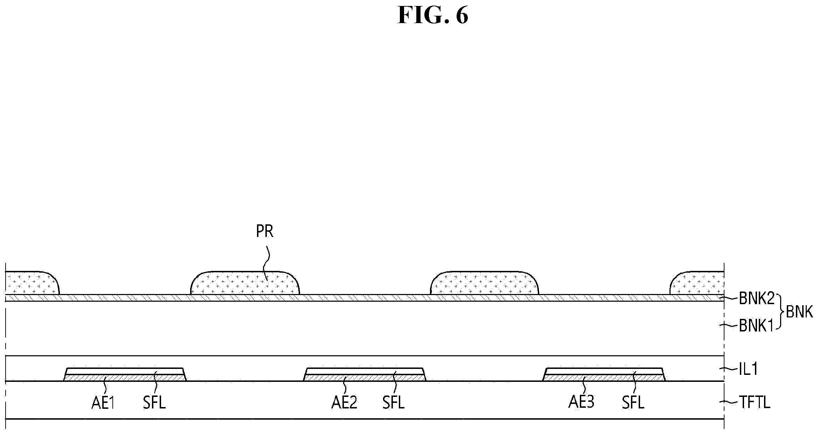

The residual patterns RP may be disposed on the edges of each of the first, second, and third pixel electrodes AE1, AE2, and AE3. The residual patterns RP may be disposed between the first insulating layer IL1 and the top surfaces of the first, second, and third pixel electrodes AE1, AE2, and AE3. The first insulating layer IL1 may not be in direct contact with the top surfaces of the first, second, and third pixel electrodes AE1, AE2, and AE3 due to the presence of the residual patterns RP. The residual patterns RP may be formed by removing a sacrificial layer ("SFL" of FIG. 6") from above the first, second, and third pixel electrodes AE1, AE2, and AE3 during the fabrication of the display device 10.

The first, second, and third light-emitting layers EL1, EL2, and EL3 may be organic light-emitting layers including or consisting of an organic material and may be formed on the first, second, and third pixel electrodes AE1, AE2, and AE3, respectively, via a deposition process. In an embodiment, during the deposition of the first, second, and third light-emitting layers EL1, EL2, and EL3, an organic material may be deposited in a diagonal direction with respect to the top surface of the substrate SUB, for example.

The first light-emitting layer EL1 may be disposed in the first emission area EA1, on the first pixel electrode AE1. Part of the first light-emitting layer EL1 may fill the space surrounded by the first pixel electrode AE1, the residual patterns RP, and the first insulating layer IL1, and another part of the first light-emitting layer EL1 may cover part of the top surface of the first insulating layer IL1 and some of the sides of the first insulating layer IL1. The second light-emitting layer EL2 may be disposed in the second emission area EA2, directly on the second pixel electrode AE2. Part of the second light-emitting layer EL2 may fill the space surrounded by the second pixel electrode AE2, the residual patterns RP, and the first insulating layer IL1, and another part of the second light-emitting layer EL2 may cover part of the top surface of the first insulating layer IL1 and some of the sides of the first insulating layer IL1. The third light-emitting layer EL3 may be disposed in the third emission area EA3, directly on the third pixel electrode AE3. Part of the third light-emitting layer EL3 may fill the space surrounded by the third pixel electrode AE3, the residual patterns RP, and the first insulating layer IL1, and another part of the third light-emitting layer EL3 may cover part of the top surface of the first insulating layer IL1 and some of the sides of the first insulating layer II,1.

The first common electrode CE1 may be disposed on the first light-emitting layer EL1, the second common electrode CE2 may be disposed on the second light-emitting layer EL2, and the third common electrode CE3 may be disposed on the third light-emitting layer EL3. The first, second, and third common electrodes CE1, CE2, and CE3 may include a transparent conductive material and may transmit light generated by the first, second, and third light-emitting layers EL1, EL2, and EL3 therethrough. The first, second, and third common electrodes CE1, CE2, and CE3 may contact the sides of the first bank BNK1 and may be electrically connected by the first bank BNK1. In an embodiment, the first common electrode CE1 may receive a common voltage, a cathode voltage, or a relatively low-potential voltage, for example.

The first pixel electrode AE1 may receive a voltage corresponding to a data voltage from one of the TFTs TR, and the first common electrode CE1 may receive a common voltage, a cathode voltage, or a relatively low-potential voltage. In this case, as a potential difference is generated between the first pixel electrode AE1 and the first common electrode CE1, holes and electrons may move to the first light-emitting layer EL1 through a hole transport layer and an electron transport layer, respectively, and as a result, the first light-emitting layer EL1 may emit light.

The etch control layer ECL may be disposed on the top surface of each of the first, second, and third common electrodes CE1, CE2, and CE3, the sides of the first bank BNK1, the bottom surfaces of the tips of the second bank BNK2, and the top surface and sides of each of the first, second, and third electrode patterns CEP1, CEP2, and CEP3. The etch control layer ECL may be formed by an atomic layer deposition ("ALD") process, but the disclosure is not limited thereto. The etch control layer ECL may be uniformly deposited on the sides of the first bank BNK1 and the bottom surfaces of the tips of the second bank BNK2 via ALD. In an embodiment, the etch control layer ECL may include at least one of indium gallium zinc oxide ("IGZO"), indium zinc oxide ("IZO"), and gallium zinc oxide ("GZO"). The etch control layer ECL may function as an etch stopper. The vaporization temperature of the etch control layer ECL for an F-based etching gas may be higher than the vaporization temperature of the first inorganic layer TL1 for the F-based etching gas. The etch control layer ECL may not be etched during a dry etching process using the F-based etching gas because of its relatively high vaporization temperature and may thus prevent the tips of the second bank BNK2 from being etched. Accordingly, the etch control layer ECL may protect the tips of the second bank BNK2 during the etching of the first and second inorganic layers TL1 and TL2. As the display device 10 includes the etch control layer ECL, the tips of the second bank BNK2 may be prevented from being damaged or bent, and the first, second, and third light-emitting layers EL1, EL2, and EL3 and the first, second, and third common electrodes CE1, CE2, and CE3 may be uniformly formed. Also, the first, second, and third light-emitting elements ED1, ED2, and ED3 may be uniformly formed, and the reliability of the display device 10 may be secured.

The capping layer CAP may be disposed on the etch control layer ECL, in the first, second, and third emission areas EA1, EA2, and EA3. The capping layer CAP may include an inorganic insulating material and may cover the first, second, and third common electrodes CE1, CE2, and CE3. The capping layer CAP may prevent the first, second, and third light-emitting elements ED 1, ED2, and ED3 from being damaged by external air. In an embodiment, the capping layer CAP may include at least one of a silicon nitride layer, a silicon oxynitride layer, a silicon oxide layer, a titanium oxide layer, an aluminium oxide layer, and an amorphous silicon layer, for example, but the disclosure is not limited thereto.

The banks BNK may be disposed on the first insulating layer IL1 to define the first, second, and third emission areas EA1, EA2, and EA3. The banks BNK may surround the first, second, and third emission areas EA1, EA2, and EA3 in a plan view. The banks BNK may include the first and second banks BNK1 and BNK2.

The first bank BNK1 may be disposed on the first insulating layer II,1, and the second bank BNK2 may be disposed on the first bank BNK1. The sides of the first bank BNK1 may be inwardly recessed from the corresponding sides of the second bank BNK2. The sides of the second bank BNK2 may protrude from the corresponding sides of the first bank BNK1 toward the first emission area EA1 and may thus include protruding tips. Thus, undercuts may be formed below the tips of the second bank BNK2. The first bank BNK1 may be thicker than the second bank BNK2.

The first and second banks BNK1 and BNK2 may include different metal materials. The first and second banks BNK1 and BNK2 may have different etching rates. In an embodiment, in a wet etching process, the first bank BNK1 may be etched faster and by a greater amount than the second bank BNK2 during the formation of the first, second, and third emission areas EA1, EA2, and EA3, for example. Thus, the shapes of the sides of the first bank BNK1 and the sides of the second bank BNK2 may be determined by the difference in etching rate between the first and second banks BNK1 and BNK2. The first bank BNK1 may include a metal material with relatively high electrical conductivity, and the second bank BNK2 may include a material with relatively low reflectance. In an embodiment, the first bank BNK1 may include Al, and the second bank BNK2 may include Ti, for example. However, the disclosure is not limited to this example.

Openings, which form the first, second, and third emission areas EA1, EA2, and EA3, may be defined in the banks BNK which may overlap with a light-blocking member BM of the color filter layer CFL. The first bank BNK1 may electrically connect the first, second, and third common electrodes CE1, CE2, and CE3, which are spaced apart from one another. The second bank BNK2 may include a material with relatively low reflectance and may thus be able to reduce the reflection of external light.

The banks BNK may form the first, second, and third emission areas EA1, EA2, and EA3 via a mask process, and the first, second, and third light-emitting layers EL1, EL2, and EL3 may be formed in the first, second, and third emission areas EA1, EA2, and EA3, respectively. A mask process may desire a structure for mounting masks and an excessively relatively large non-display area NDA for distribution control. When mask processes may be minimized, the structure for mounting masks may not be provided, and the size of the non-display area NDA for distribution control may be minimized.

The first, second, and third light-emitting elements ED1, ED2, and ED3 may be formed by deposition and etching processes, rather than by a mask process. As the first and second banks BNK1 and BNK2 include different metal materials, the inner sidewalls of each of the banks BNK may include tips, and different layers may be formed separately in each of the first, second, and third emission areas EA1, EA2, and EA3 via a deposition process. In an embodiment, the first light-emitting layer EL1 and the first organic pattern ELP1 may include or consist of the same organic material by a deposition process not using a mask and may be cut and separated from each other by the tips on the inner sidewalls of each of the banks BNK, for example. The first light-emitting layer EL1 may be disposed in the first emission area EA1, and the first organic pattern ELP1 may be disposed on parts of the banks BNK around the first emission area EA1.

An organic material for forming the first light-emitting layer EL1 may be deposited on the entirety of the surface of the display device 10 and may be removed from the second and third emission areas EA2 and EA3. An organic material for forming the second light-emitting layer EL2 may be deposited on the entirety of the surface of the display device 10 and may be removed from the first and third emission areas EA1 and EA3. An organic material for forming the third light-emitting layer EL3 may be deposited on the entirety of the surface of the display device 10 and may be removed from the first and second emission areas EA1 and EA2. Accordingly, different organic layers may be formed in different emission areas by deposition and etching processes, rather than by a mask process. As unnecessary processes may be omitted, the manufacturing cost of the display device 10 may be reduced, and the size of the non-display area NDA may be minimized.

The first organic pattern ELP1 may include the same organic material as that of the first light-emitting layer EL1 and may be disposed on the second bank BNK2. The first organic pattern ELP1 may cover the top surface and sides of part of the second bank BNK2 around the first emission area EA1. The first light-emitting layer EL1 and the first organic pattern ELP1 may be deposited by the same process and may be cut and separated from each other by the tips formed on second bank BNK2. Accordingly, the first organic pattern ELP1 may be disposed on the second bank BNK2, in an area around the first emission area EA1.

The first electrode pattern CEP1 may include the same metal material as that of the first common electrode CE1 and may be disposed on the first organic pattern ELP1. The first electrode pattern CEP1 may cover the top surface and sides of the first organic pattern ELP1. The first common electrode CE1 and the first electrode pattern CEP1 may be deposited by the same process and may be cut and separated by the tips of the second bank BNK2. Accordingly, the first electrode pattern CEP1 may be disposed on the first organic pattern ELP1, in the area around the first emission area EA1.

The first capping pattern CLP1 may include the same inorganic material as that of the capping layer CAP and may be disposed in the first emission area EA1, on the etch control layer ECL. The first capping pattern CLP1 may cover the top surface and sides of part of the etch control layer ECL covering the first electrode pattern CEP1. The capping layer CAP and the first capping pattern CLP1 may be deposited by the same process and may be cut and separated by the tips of the second bank BNK2. Accordingly, the first capping pattern CLP1 may be disposed on the part of the etch control layer ECL covering the first electrode pattern CEP1.

The first inorganic layer TL1 may be disposed in the first emission area EA1, on the top surface of the capping layer CAP, the sides of the etch control layer ECL, and the top surface and sides of the first capping pattern CLP1. The first inorganic layer TL1 may be disposed in the first emission area EA1 to cover the sides of the etch control layer ECL that cover the corresponding sides of the first bank BNK1. The first inorganic layer TL1 may include an inorganic material and may prevent oxygen or moisture from penetrating the first light-emitting element ED1. The first inorganic layer TL1 may be an inorganic encapsulation layer. In an embodiment, the first inorganic layer TL1 may include at least one of a silicon nitride layer, a silicon oxynitride layer, a silicon oxide layer, a titanium oxide layer, an aluminium oxide layer, and an amorphous silicon layer, for example, but the disclosure is not limited thereto.

The second organic pattern ELP2 may include the same organic material as that of the second light-emitting layer EL2 and may be disposed on the second bank BNK2. The second organic pattern ELP2 may cover the top surface and sides of part of the second bank BNK2 around the second emission area EA2. The second light-emitting layer EL2 and the second organic pattern ELP2 may be deposited by the same process and may be cut and separated by the tips of the second bank BNK2. Accordingly, the second organic pattern ELP2 may be disposed on the second bank BNK2, in an area around the second emission area EA2.

The second electrode pattern CEP2 may include the same material as that of the second common electrode CE2 and may be disposed on the second organic pattern ELP2. The second electrode pattern CEP2 may cover the top surface and sides of the second organic pattern ELP2. The second common electrode CE2 and the second electrode pattern CEP2 may be deposited by the same process and may be cut and separated by the tips of the second bank BNK2. Accordingly, the second electrode pattern CEP2 may be disposed on the second organic pattern ELP2, in the area around the second emission area EA2.

The second capping pattern CLP2 may include the same inorganic material as that of the capping layer CAP and may be disposed in the second emission area EA2, on the etch control layer ECL. The second capping pattern CLP2 may cover the top surface and sides of part of the etch control layer ECL covering the second electrode pattern CEP2. The capping layer CAP and the second capping pattern CLP2 may be deposited by the same process and may be cut and separated by the tips of the second bank BNK2. Accordingly, the second capping pattern CLP2 may be disposed on the part of the etch control layer ECL covering the second electrode pattern CEP2.

The second inorganic layer TL2 may be disposed in the second emission area EA2, on the top surface of the capping layer CAP, the sides of the etch control layer ECL, and the top surface and sides of the second capping pattern CLP2. The second inorganic layer TL2 may be disposed in the second emission area EA2 to cover the sides of the etch control layer ECL that cover the corresponding sides of the second bank BNK2. The second inorganic layer TL2 may include an inorganic material and may prevent oxygen or moisture from penetrating the second light-emitting element ED2. The second inorganic layer TL2 may be an inorganic encapsulation layer. In an embodiment, the second inorganic layer TL2 may include or consist of one of the aforementioned example materials for forming the first inorganic layer TL1, for example.

The third organic pattern ELP3 may include the same organic material as that of the third light-emitting layer EL3 and may be disposed on the second bank BNK2. The third organic pattern ELP3 may cover the top surface and sides of part of the second bank BNK2 around the third emission area EA3. The third light-emitting layer EL3 and the third organic pattern ELP3 may be deposited by the same process and may be cut by the tips of the second bank BNK2. Accordingly, the third organic pattern ELP3 may be disposed on the second bank BNK2, in the area around the third emission area EA3.

The third electrode pattern CEP3 may include the same metal material as that of the third common electrode CE3 and may be disposed on the third organic pattern ELP3. The third electrode pattern CEP3 may cover the top surface and sides of the third organic pattern ELP3. The third common electrode CE3 and the third electrode pattern CEP3 may be deposited by the same process and may be cut and separated by the tips of the second bank BNK2. Accordingly, the third electrode pattern CEP3 may be disposed on the third organic pattern ELP3, in the area around the third emission area EA3.

The third capping pattern CLP3 may include the same inorganic material as that of the capping layer CAP and may be disposed in the third emission area EA3, on the etch control layer ECL. The third capping pattern CLP3 may cover the top surface and sides of part of the etch control layer ECL covering the third electrode pattern CEP3. The capping layer CAP and the third capping pattern CLP3 may be deposited by the same process and may be cut and separated by the tips of the second bank BNK2. Accordingly, the third capping pattern CLP3 may be disposed on the part of the etch control layer ECL covering the third electrode pattern CEP3.

The third inorganic layer TL3 may be disposed in the third emission area EA3, on the top surface of the capping layer CAP, the sides of the etch control layer ECL, and the top surface and sides of the third capping pattern CLP3. The third inorganic layer TL3 may be disposed in the third emission area EA3 to cover the sides of the etch control layer ECL that cover the corresponding sides of the first bank BNK1. The third inorganic layer TL3 may include an inorganic material and may prevent oxygen or moisture from penetrating the third light-emitting element ED3. The third inorganic layer TL3 may be an inorganic encapsulation layer. In an embodiment, the third inorganic layer TL3 may include or consist of one of the aforementioned example materials for forming the first inorganic layer TL1, for example.

The encapsulation layer TFEL may be disposed on the first, second, and third inorganic layers TL1, TL2, and TL3 to cover the light-emitting element layer EML. The encapsulation layer TFEL may include first, second, and third encapsulation layers TFE1, TFE2, and TFE3.

The first encapsulation layer TFE1 may be disposed on the first, second, and third inorganic layers TL1, TL2, and TL3. The first encapsulation layer TFE1 may cover exposed parts of the second bank BNK2 between the first, second, and third inorganic layers TL1, TL2, and TL3. The first encapsulation layer TFE1 may include an inorganic material and may thus prevent the penetration of oxygen or moisture into the light-emitting element layer EML. In an embodiment, the first encapsulation layer TFE1 may include at least one of a silicon nitride layer, a silicon oxynitride layer, a silicon oxide layer, a titanium oxide layer, an aluminium oxide layer, and an amorphous silicon layer, for example, but the disclosure is not limited thereto.

The second encapsulation layer TFE2 may be disposed on the first encapsulation layer TFE1 to planarize the top of the light-emitting element layer EML. The second encapsulation layer TFE2 may include an organic material and may protect the light-emitting element layer EML from a foreign material such as dust. In an embodiment, the second encapsulation layer TFE2 may include an organic film including or consisting of an acrylic resin, an epoxy resin, a phenolic resin, a polyamide resin, or a PI resin, for example. The second encapsulation layer TFE2 may be formed by curing a monomer or applying a polymer.

The third encapsulation layer TFE3 may be disposed on the first encapsulation layer TFE1. The third encapsulation layer TFE3 may include an inorganic material and may prevent oxygen or moisture from penetrating the light-emitting element layer EML. In an embodiment, the third encapsulation layer TFE3 may include or consist of one of the aforementioned example materials for forming the first encapsulation layer TFE1, for example.

The touch sensing unit TSU may be disposed on the encapsulation layer TFEL. The touch sensing unit TSU may include a third buffer layer BF3, bridge electrodes BRG, a second insulating layer IL2, touch electrodes TE, and a third insulating layer IL3.

The third buffer layer BF3 may be disposed on the encapsulation layer TFEL. The third buffer layer BF3 may have an insulation function and an optical function. The third buffer layer BF3 may include at least one inorganic film. In some embodiments, the third buffer layer BF3 may not be provided.

The bridge electrodes BRG may be disposed on the third buffer layer BF3. The bridge electrodes BRG may be disposed in a different layer from the touch electrodes TE and may electrically connect the touch electrodes TE to one another.

The second insulating layer IL2 may be disposed on the bridge electrodes BRG and the third buffer layer BF3. The second insulating layer IL2 may have an insulation function and an optical function. In an embodiment, the second insulating layer IL2 may include at least one of a silicon nitride layer, a silicon oxynitride layer, a silicon oxide layer, a titanium oxide layer, an aluminium oxide layer, and an amorphous silicon layer, for example, but the disclosure is not limited thereto.

The touch electrodes TE may be disposed on the second insulating layer IL2. The touch electrodes TE may include driving electrodes and sensing electrodes and may sense variations in the mutual capacitance between the driving electrodes and the sensing electrodes. The touch electrodes TE may not overlap with the first, second, and third emission areas EA1, EA2, and EA3. The touch electrodes TE may be formed as single layers including Mo, Ti, Cu, Al, or ITO or as stacks of Al and Ti (e.g., (Ti/Al/Ti), stacks of Al and ITO (e.g., ITO/Al/ITO), layers of a silver (Ag)-palladium (Pd)-copper (Cu) (APC) alloy, or stacks of an APC alloy and ITO (e.g., ITO/APC/ITO).

The third insulating layer IL3 may be disposed on the touch electrodes TE and the second insulating layer IL2. The third insulating layer IL3 may have an insulation function and an optical function. The third insulating layer IL3 may include or consist of one of the aforementioned example materials for forming the second insulating layer IL2.

The color filer layer CFL may be disposed on the touch sensing unit TSU. The color filter layer CFL may include the light-blocking member BM, a plurality of color filters, and a planarization layer OC.

The light-blocking member BM may be disposed on the third insulating layer IL3 and may surround first, second, and third optical areas OPT1, OPT2, and OPT3. The light-blocking member BM may overlap with the touch electrodes TE. The light-blocking member BM may include a light-absorbing material and may prevent the reflection of light. In an embodiment, the light-blocking member BM may include an inorganic black pigment, an organic black pigment, or an organic blue pigment, for example. The inorganic black pigment may be a metal oxide such as carbon black or Ti black, the organic black pigment may be at least one of lactam black, perylene black, and aniline black, and the organic blue pigment may be C.I. pigment blue. However, the disclosure is not limited to this. The light-blocking member BM may improve the color reproducibility of the display device 10 by preventing visible light from penetrating between the first, second, and third emission areas EA1, EA2, and EA3 to cause color mixing.

The color filters may include first, second, and third color filters CF1, CF2, and CF3. The first, second, and third color filters CF1, CF2, and CF3 may be disposed on the third insulating layer IL3 to correspond to the first, second, and third emission areas EA1, EA2, and EA3, respectively.

The first color filter CF1 may be disposed in the first emission area EA1, on the third insulating layer IL3. The first color filter CF1 may be surrounded by the first emission area EA1, in a plan view. The edges of the first color filter CF1 may cover part of the top surface of the light-blocking member BM, but the disclosure is not limited thereto. The first color filter CF1 may selectively transmit first-color light (e.g., red light) therethrough and may block or absorb second-color light (e.g., green light) and third-color light (e.g., blue light). In an embodiment, the first color filter CF1 may be a red color filter and may include a red colorant, for example.

The second color filter CF2 may be disposed in the second emission area EA2, on the third insulating layer IL3. The second color filter CF2 may be surrounded by the second emission area EA2, in a plan view. The edges of the second color filter CF2 may cover part of the top surface of the light-blocking member BM, but the disclosure is not limited thereto. The second color filter CF2 may selectively transmit second-color light (e.g., green light) therethrough and may block or absorb first-color light (e.g., red light) and third-color light (e.g., blue light). In an embodiment, the second color filter CF2 may be a green color filter and may include a green colorant, for example.

The third color filter CF3 may be disposed in the third emission area EA3, on the third insulating layer IL3. The third color filter CF3 may be surrounded by the third emission area EA3, in a plan view. The edges of the third color filter CF3 may cover part of the top surface of the light-blocking member BM, but the disclosure is not limited thereto. The third color filter CF3 may selectively transmit third-color light (e.g., blue light) therethrough and may block or absorb first-color light (e.g., red light) and second-color light (e.g., green light). In an embodiment, the third color filter CF3 may be a blue color filter and may include a blue colorant, for example.

The first, second, and third color filters CF1, CF2, and CF3 may reduce reflected light of external light by absorbing some of the external light. Accordingly, the first, second, and third color filters CF1, CF2, and CF3 may prevent color distortion that may be caused by the reflection of the external light.

The planarization layer OC may be disposed on the light-blocking member BM and the first, second, and third color filters CF1, CF2, and CF3. The planarization layer OC may planarize the top of the color filter layer CFL. In an embodiment, the planarization layer OC may include an organic insulating material, for example.

FIGS. 6 through 15 are cross-sectional views illustrating an embodiment of a method of manufacturing a display device according to the disclosure.

Referring to FIG. 6, first, second, and third pixel electrodes AE1, AE2, and AE3 may be spaced apart from one another on a TFT layer TFTL. In an embodiment, the first, second, and third pixel electrodes AE1, AE2, and AE3 may include at least one of Ag, Cu, Al, Ni, and La, for example. In another embodiment, the first, second, and third pixel electrodes AE1, AE2, and AE3 may include ITO, IZO, or ITZO. In another embodiment, the first, second, and third pixel electrodes AE1, AE2, and AE3 may have a stack structure such as ITO/Ag/ITO/, ITO/Ag/IZO, or ITO/Ag/ITZO/IZO.

A sacrificial layer SFL may be disposed on the first, second, and third pixel electrodes AE1, AE2, and AE3. The sacrificial layer SFL may be disposed between the top surfaces of the first, second, and third pixel electrodes AE1, AE2, and AE3 and a first insulating layer IL1. The sacrificial layer SFL may include an oxide semiconductor. In an embodiment, the sacrificial layer SFL may include at least one of indium gallium zinc oxide ("IZO"), zinc tin oxide ("ZTO"), and IZO, for example.

The first insulating layer IL1 may be disposed on the TFT layer TFTL and the sacrificial layer SFL. The first insulating layer IL1 may include an inorganic insulating material. The first insulating layer IL1 may include at least one of a silicon nitride layer, a silicon oxynitride layer, a silicon oxide layer, a titanium oxide layer, an aluminium oxide layer, and an amorphous silicon layer, but the disclosure is not limited thereto.

A first bank BNK1 may be disposed on the first insulating layer IL1, and a second bank BNK2 may be disposed on the first bank BNK1. The first bank BNK1 may be thicker than the second bank BNK2.

Photoresist PR may be disposed on the second bank BNK2 not to overlap with the first, second, and third pixel electrodes AE1, AE2, and AE3. The photoresist PR may be provided in regions other than regions in which first, second, and third emission areas EA1, EA2, and EA3 are to be formed.

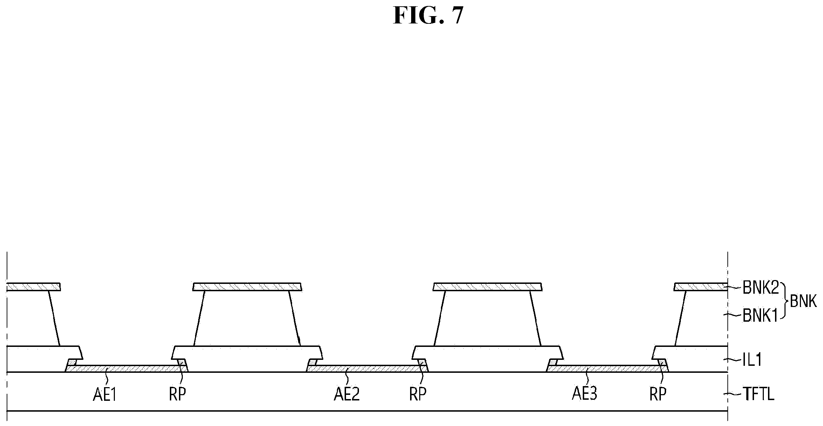

Referring to FIG. 7, the second bank BNK2 and the first bank BNK1 may be sequentially etched using the photoresist PR as a mask, and a plurality of holes may be formed. The holes may overlap with the first, second, and third emission areas EA1, EA2, and EA3. The first and second banks BNK1 and BNK2 may be etched by at least one of dry etching and wet etching. In an embodiment, the first and second banks BNK1 and BNK2 may be etched primarily by dry etching and secondarily by wet etching, for example, but the disclosure is not limited thereto. The first and second banks BNK1 and BNK2 may include different metal materials and may have different etching rates. In a wet etching process, the first bank BNK1 may be etched faster and by a greater amount than the second bank BNK2. Thus, the shapes of the sides of the first bank BNK1 and the sides of the second bank BNK2 may be determined by the difference in etching rate between the first and second banks BNK1 and BNK2. The second bank BNK2 may include tips projected from the first bank BNK1 toward the holes. The sides of the first bank BNK1 may be inwardly recessed from the corresponding sides of the second bank BNK2. Undercuts may be formed below the tips of the second bank BNK2. The first bank BNK1 may be thicker than the second bank BNK2.

The first bank BNK1 may include a metal material with relatively high electrical conductivity, and the second bank BNK2 may include a material with relatively low reflectance. In an embodiment, the first bank BNK1 may include Al, and the second bank BNK2 may include Ti, for example. However, the disclosure is not limited to this example.

The first insulating layer IL1 and the sacrificial layer SFL may be etched by at least one of dry etching and wet etching. In an embodiment, the first insulating layer IL1 may be etched by dry etching, and the sacrificial layer SFL may be etched by wet etching, for example. However, the disclosure is not limited to this example. As the first insulating layer IL1 and the sacrificial layer SFL are etched, at least parts of the top surfaces of the first, second, and third pixel electrodes AE1, AE2, and AE3 may be exposed. In a wet etching process, the sacrificial layer SFL may be etched by a greater amount than the first insulating layer IL1. As the sacrificial layer SFL is etched, residual patterns RP may remain between the first insulating layer IL1 and the first pixel electrode AE1. Accordingly, the sides of each of the residual patterns RP may be inwardly recessed from the sides of the first insulating layer IL1.

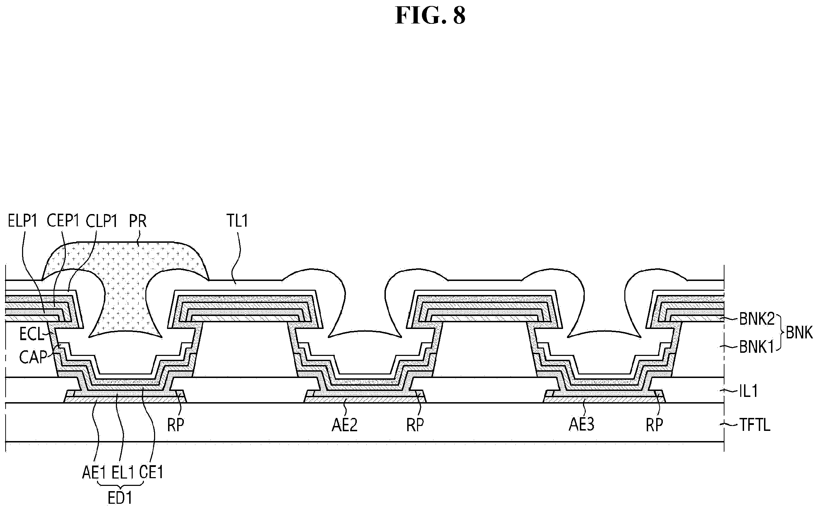

Referring to FIG. 8, a first light-emitting layer EL1 may be disposed directly on the first pixel electrode AE1, in the first emission area EA1. Part of the first light-emitting layer EL1 may fill the space surrounded by the first pixel electrode AE1, one of the residual patterns RP, and the first insulating layer IL1, and another part of the first light-emitting layer EL1 may cover part of the top surface of the first insulating layer IL1 and some of the sides of the first insulating layer IL1. The first light-emitting layer EL1 may be disposed directly on the second pixel electrode AE2, in the second emission area AE2, and directly on the third pixel electrode AE3, in the third emission area EA3.

An organic material for forming the first light-emitting layer EL1 and the first organic pattern ELP1 may be deposited on the entirety of the surface of a display device 10. The first organic pattern ELP1 may include the same organic material as that of the first light-emitting layer EL1 and may be disposed on the second bank BNK2. The first organic pattern ELP1 may cover the top surface and sides of part of the second bank BNK2 around the first emission area EA1. The first light-emitting layer EL1 and the first organic pattern ELP1 may be deposited by the same process and may be cut and separated by the tips of the second bank BNK2. Accordingly, the first organic pattern ELP1 may be disposed on the second bank BNK2, in areas other than the first, second, and third emission areas EA1, EA2, and EA3.

A first common electrode CE1 may be disposed directly on the first light-emitting layer EL1, in the first emission area EA1. The first common electrode CE1 may contact the sides of the first bank BNK1. The first common electrode CE1 may include a transparent conductive material and may transmit light generated by the first light-emitting layer EL1 therethrough. Accordingly, the first light-emitting element ED1 may be formed in one of the holes in the banks BNK and may emit light through the first emission area EA1. The first common electrode CE1 may be disposed directly on the first light-emitting layer EL1, in the second and third emission areas EA2 and EA3.

A metal material for forming the first common electrode CE1 and a first electrode pattern CEP1 may be deposited on the entirety of the surface of the display device 10. The first electrode pattern CEP1 may include the same metal material as that of the first common electrode CE1 and may be disposed on the first organic pattern ELP1. The first electrode pattern CEP1 may cover the top surface and sides of the first organic pattern ELP1. The first common electrode CE1 and the first electrode pattern CEP1 may be deposited by the same process and may be cut and separated by the tips of the second bank BNK2. Accordingly, the first electrode pattern CEP1 may be disposed on the first organic pattern ELP1, in the areas other than the first, second, and third emission areas EA1, EA2, and EA3.

A material for forming an etch control layer ECL may be deposited on the entirety of the surface of the display device 10. The etch control layer ECL may be disposed on the top surface of the first common electrode CE1, the sides of the first bank BNK1, the bottom surfaces of the tips of the second bank BNK2, and the top surface and sides of the first electrode pattern CEP1. The etch control layer ECL may be formed by an ALD process, but the disclosure is not limited thereto. The etch control layer ECL may be uniformly deposited on the sides of the first bank BNK1 and the bottom surfaces of the tips of the second bank BNK2, via ALD. In an embodiment, the etch control layer ECL may include at least one of IGZO, IZO, and GZO, for example.

A capping layer CAP may be disposed on the etch control layer ECL, in the first emission area EA1. The capping layer CAP may include an inorganic insulating material and may cover the first light-emitting element ED1. The capping layer CAP may prevent the first common electrode CE1 from being damaged by external air. In an embodiment, the capping layer CAP may include at least one of a silicon nitride layer, a silicon oxynitride layer, a silicon oxide layer, a titanium oxide layer, an aluminium oxide layer, and an amorphous silicon layer, for example, but the disclosure is not limited thereto. The capping layer CAP may be disposed on the etch control layer ECL, in the second and third emission areas EA2 and EA3.

An inorganic material for forming the capping layer CAP and a first capping pattern CLP1 may be deposited on the entirety of the surface of the display device 10. The first capping pattern CLP1 may include the same inorganic material as that of the capping layer CAP and may be disposed on the etch control layer ECL. The first capping pattern CLP1 may cover the sides of the part of the first electrode pattern CEP1 around the first emission area EA1. The capping layer CAP and the first capping pattern CLP1 may be deposited by the same process and may be cut and separated by the tips of the second bank BNK2. Accordingly, the first capping pattern CLP1 may be disposed on the first electrode pattern CEP1, in the areas other than the first, second, and third emission areas EA1, EA2, and EA3.

An inorganic material for forming a first inorganic layer TL1 may be deposited on the entirety of the surface of the display device 10. The first inorganic layer TL1 may be disposed on the top surface of the capping layer CAP, the sides of the etch control layer ECL, and the top surface and sides of the first capping pattern CLP1. The first inorganic layer TL1 may include an inorganic material and may prevent oxygen or moisture from penetrating the first light-emitting element ED1. The first inorganic layer TL1 may be an inorganic encapsulation layer. In an embodiment, the first inorganic layer TL1 may include at least one of a silicon nitride layer, a silicon oxynitride layer, a silicon oxide layer, a titanium oxide layer, an aluminium oxide layer, and an amorphous silicon layer, for example, but the disclosure is not limited thereto.

The photoresist PR may also be disposed on the first inorganic layer TL1, in the first emission area EA1. The photoresist PR may be provided on the first inorganic layer TL1, in areas other than the second and third emission areas EA2 and EA3, and may be used as a mask during an etching process.

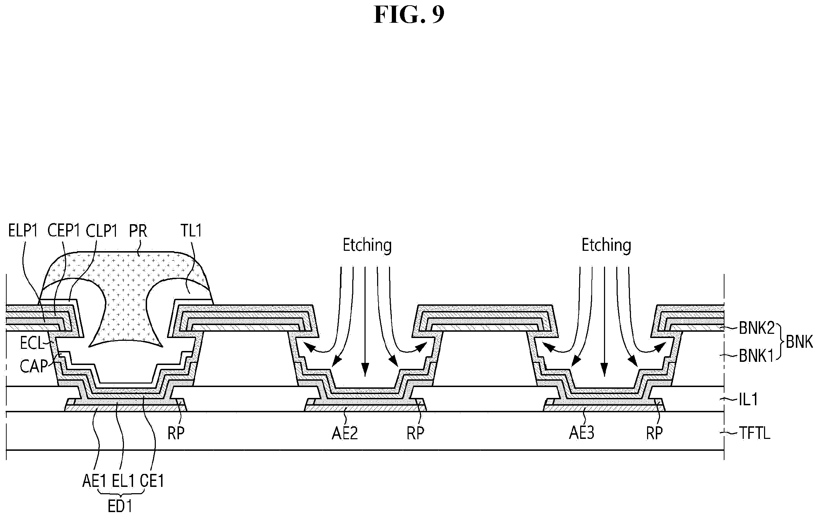

Referring to FIG. 9, parts of the first inorganic layer TL1, the first capping pattern CLP1, and the capping layer CAP that are not covered by the photoresist PR may be etched by an etching process. The first inorganic layer TL1, the first capping pattern CLP1, and the capping layer CAP may be etched by an isotropic etching process. In an embodiment, the first inorganic layer TL1, the first capping pattern CLP1, and the capping layer CAP may be etched by a dry etching process using an F-based etching gas, for example.

The etch control layer ECL may function as an etch stopper. The vaporization temperature of the etch control layer ECL for the F-based etching gas may be higher than the vaporization temperature of the first inorganic layer TL1 for the F-based etching gas. The etch control layer ECL may not be etched during the dry etching process using the F-based etching gas because of its relatively high vaporization temperature and may thus prevent the tips of the second bank BNK2 from being etched. Accordingly, the etch control layer ECL may protect the tips of the second bank BNK2, around the second and third emission areas EA2 and EA3, during the etching of the first inorganic layer TL1. As the display device 10 includes the etch control layer ECL, the tips of the second bank BNK2 may be prevented from being damaged or bent.

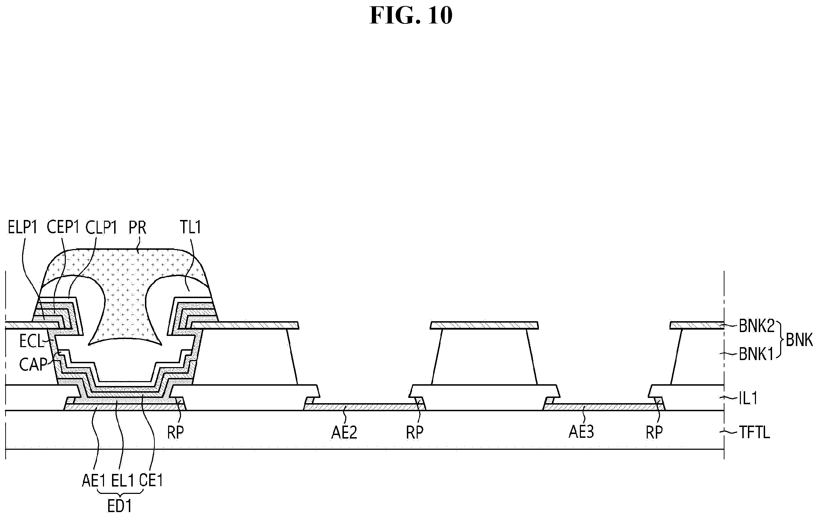

Referring to FIG. 10, parts of the etch control layer ECL, the first electrode pattern CEP1, the first organic pattern ELP1, the first common electrode CE1, and the first light-emitting layer EL1 that are not covered by the photoresist PR may be etched by an etching process. In an embodiment, the etch control layer ECL, the first electrode pattern CEP1, the first organic pattern ELP1, the first common electrode CE1, and the first light-emitting layer EL1 may be etched by a wet etching process, for example, but the disclosure is not limited thereto. Accordingly, the second pixel electrode AE2 may be exposed in the second emission area EA2, and the third pixel electrode AE3 may be exposed in the third emission area EA3.

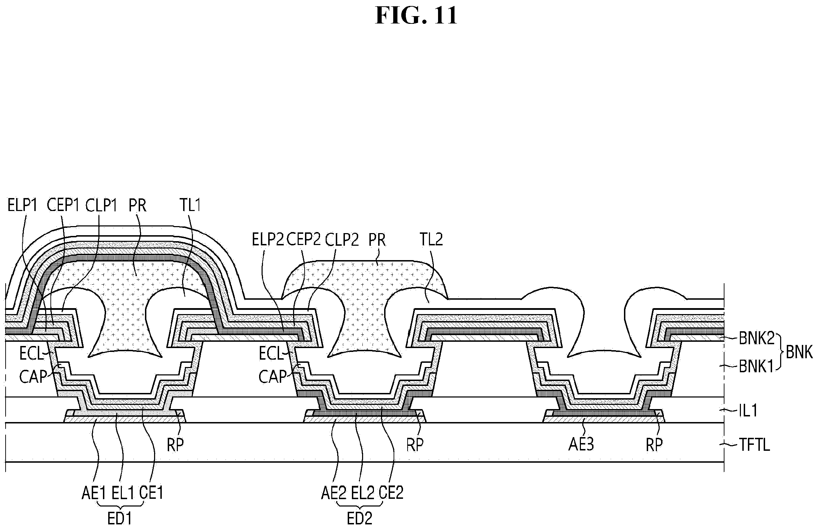

Referring to FIG. 11, a second light-emitting layer EL2 may be disposed directly on the second pixel electrode AE2, in the second emission area EA2. Part of the second light-emitting layer EL2 may fill the space surrounded by the second pixel electrode AE2, one of the residual patterns RP, and the first insulating layer IL1, and another part of the second light-emitting layer EL2 may cover part of the top surface of the first insulating layer IL1 and some of the sides of the first insulating layer IL1. The second light-emitting layer EL2 may be disposed directly on the third pixel electrode AE3, in the third emission area EA3.

An organic material for forming the second light-emitting layer EL2 and a second organic pattern ELP2 may be deposited on the entirety of the surface of the display device 10. The second organic pattern ELP2 may include the same organic material as that of the second light-emitting layer EL2 and may be disposed on the second bank BNK2. The second organic pattern ELP2 may cover the top surface and sides of the second bank BNK2. The second light-emitting layer EL2 and the second organic pattern ELP2 may be deposited by the same process and may be cut and separated by the tips of the second bank BNK2. Accordingly, the second organic pattern ELP2 may be disposed on the second bank BNK2, in the areas other than the first, second, and third emission areas EA1, EA2, and EA3.

A second common electrode CE2 may be disposed directly on the second light-emitting layer EL2, in the second emission area EA2. The second common electrode CE2 may contact the sides of the first bank BNK1. The second common electrode CE2 may include a transparent conductive material and may transmit light generated by the second light-emitting layer EL2 therethrough. Accordingly, the second light-emitting element ED2 may be formed in one of the holes in the banks BNK and may emit light through the second emission area EA2. The second common electrode CE2 may be disposed directly on the second light-emitting layer EL2, in the third emission area EA3.

A metal material for forming the second common electrode CE2 and a second electrode pattern CEP2 may be deposited on the entirety of the surface of the display device 10. The second electrode pattern CEP2 may include the same metal material as that of the second common electrode CE2 and may be disposed on the second organic pattern ELP2. The second electrode pattern CEP2 may cover the top surface and sides of the second organic pattern ELP2. The second common electrode CE2 and the second electrode pattern CEP2 may be deposited by the same process and may be cut and separated by the tips of the second bank BNK2. Accordingly, the second electrode pattern CEP2 may be disposed on the second organic pattern ELP2, in the areas other than the first, second, and third emission areas EA1, EA2, and EA3.

The material for forming the etch control layer ECL may be deposited on the entirety of the surface of the display device 10. The etch control layer ECL may also be disposed on the top surface of the second common electrode CE2, the sides of the first bank BNK1, the bottom surfaces of the tips of the second bank BNK2, and the top surface and sides of the second electrode pattern CEP2. The etch control layer ECL may be formed by an ALD process, but the disclosure is not limited thereto. The etch control layer ECL may be uniformly deposited on the sides of the first bank BNK1 and the bottom surfaces of the tips of the second bank BNK2, via ALD. In an embodiment, the etch control layer ECL may include at least one of IGZO, IZO, and GZO, for example.

The capping layer CAP may also be disposed on the etch control layer ECL, in the second emission area EA2. The capping layer CAP may include an inorganic insulating material and may cover the second light-emitting element ED2. The capping layer CAP may prevent the second light-emitting element ED2 from being damaged by external air. The capping layer CAP may be disposed on the etch control layer ECL, in the third emission area EA3.

An inorganic material for forming the capping layer CAP and a second capping pattern CLP2 may be deposited on the entirety of the surface of the display device 10. The second capping pattern CLP2 may include the same inorganic material as that of the capping layer CAP and may be disposed on the etch control layer ECL. The second capping pattern CLP2 may cover the sides of the second electrode pattern CEP2 around the second emission area EA2. The capping layer CAP and the second capping pattern CLP2 may be deposited by the same process and may be cut and separated by the tips of the second bank BNK2. Accordingly, the second capping pattern CLP2 may be disposed on the second electrode pattern CEP2, in the areas other than the first, second, and third emission areas EA1, EA2, and EA3.

An inorganic material for forming a second inorganic layer TL2 may be deposited on the entirety of the surface of the display device 10. The second inorganic layer TL2 may be disposed on the top surface of the capping layer CAP, the sides of the etch control layer ECL, and the top surface and sides of the second capping pattern CLP2. The second inorganic layer TL2 may include an inorganic material and may prevent oxygen or moisture from penetrating the second light-emitting element ED2. The second inorganic layer TL2 may be an inorganic encapsulation layer. In an embodiment, the second inorganic layer TL2 may include or consist of one of the aforementioned example materials for forming the first inorganic layer TL1, for example.

The photoresist PR may also be disposed on the second inorganic layer TL2, in the second emission area EA2. The photoresist PR may be provided on the second inorganic layer TL2, in the areas other than the first, second, and third emission areas EA1, EA2, and EA3, and may be used as a mask during an etching process.

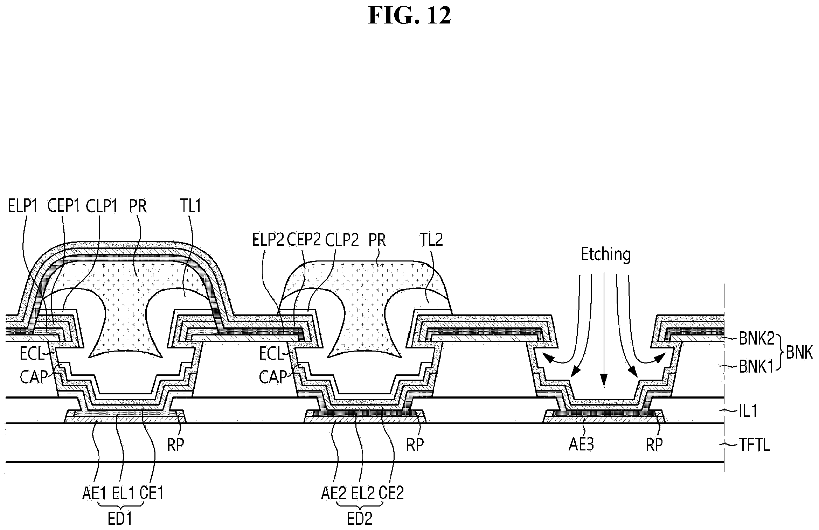

Referring to FIG. 12, parts of the second inorganic layer TL2, the second capping pattern CLP2, and the capping layer CAP that are not covered by the photoresist PR may be etched by an etching process. The second inorganic layer TL2, the second capping pattern CLP2, and the capping layer CAP may be etched by an isotropic etching process. In an embodiment, the second inorganic layer TL2, the second capping pattern CLP2, and the capping layer CAP may be etched by a dry etching process using the F-based etching gas, for example.

The etch control layer ECL may function as an etch stopper. The vaporization temperature of the etch control layer ECL for the F-based etching gas may be higher than the vaporization temperature of the first inorganic layer TL1 for the F-based etching gas. The etch control layer ECL may not be etched during the dry etching process using the F-based etching gas because of its relatively high vaporization temperature and may thus prevent the tips of the second bank BNK2 from being etched. Accordingly, the etch control layer ECL may protect the tips of the second bank BNK2, around the second and third emission areas EA2 and EA3, during the etching of the second inorganic layer TL2. As the display device 10 includes the etch control layer ECL, the tips of the second bank BNK2 may be prevented from being damaged or bent.

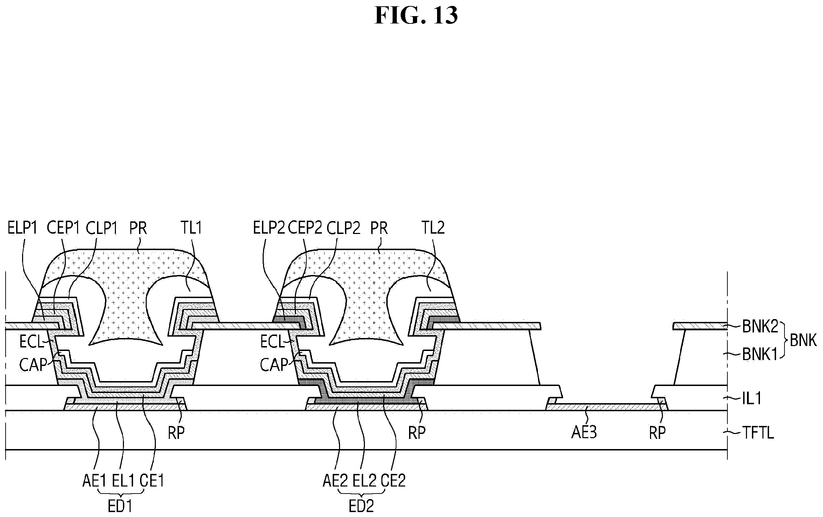

Referring to FIG. 13, parts of the etch control layer ECL, the second electrode pattern CEP2, the second organic pattern ELP2, the second common electrode CE2, and the second light-emitting layer EL2 that are not covered by the photoresist PR may be etched by an etching process. In an embodiment, the etch control layer ECL, the second electrode pattern CEP2, the second organic pattern ELP2, the second common electrode CE2, and the second light-emitting layer EL2 may be etched by a wet etching process, for example, but the disclosure is not limited thereto. Accordingly, the third pixel electrode AE3 may be exposed in the third emission area EA3.

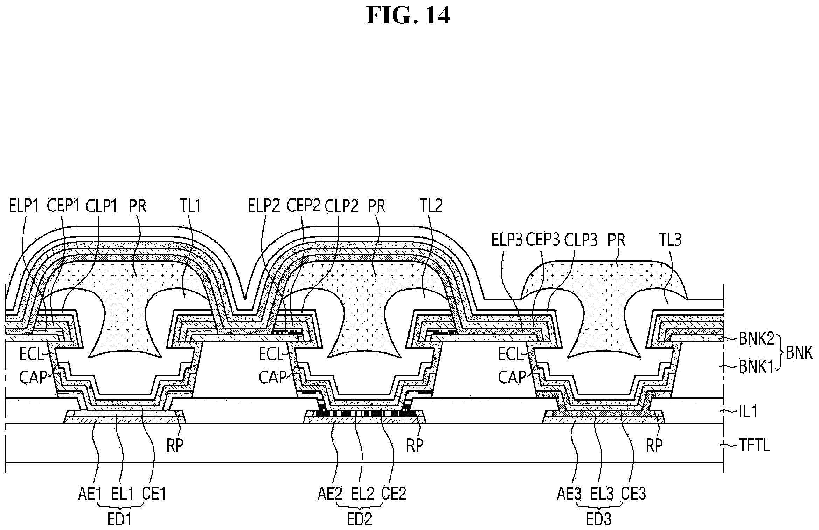

Referring to FIG. 14, a third light-emitting layer EL3 may be disposed directly on the third pixel electrode AE3, in the third emission area EA3. Part of the third light-emitting layer EL3 may fill the space surrounded by the third pixel electrode AE3, one of the residual patterns RP, and the first insulating layer II,1, and another part of the third light-emitting layer EL3 may cover part of the top surface of the first insulating layer IL1 and some of the sides of the first insulating layer IL1.

The organic material for forming the third light-emitting layer EL3 and a third organic pattern ELP3 may be deposited on the entirety of the surface of the display device 10. The third organic pattern ELP3 may include the same organic material as that of the third light-emitting layer EL3 and may be disposed on the second bank BNK2. The third organic pattern ELP3 may cover the top surface and sides of the second bank BNK2. The third light-emitting layer EL3 and the third organic pattern ELP3 may be deposited by the same process and may be cut and separated by the tips of the second bank BNK2. Accordingly, the third organic pattern ELP3 may be disposed on the second bank BNK2, in the areas other than the first, second, and third emission areas EA1, EA2, and EA3.

A third common electrode CE3 may be disposed directly on the third light-emitting layer EL3, in the third emission area EA3. The third common electrode CE3 may contact the sides of the first bank BNK1. The third common electrode CE3 may include a transparent conductive material and may transmit light generated by the third light-emitting layer EL3 therethrough. Accordingly, the third light-emitting element ED3 may be formed in one of the holes in the banks BNK and may emit light through the third emission area EA3.

A metal material for forming the third common electrode CE3 and a third electrode pattern CEP3 may be deposited on the entirety of the surface of the display device 10. The third electrode pattern CEP3 may include the same metal material as that of the third common electrode CE3 and may be disposed on the third organic pattern ELP3. The third electrode pattern CEP3 may cover the top surface and sides of the third organic pattern ELP3. The third common electrode CE3 and the third electrode pattern CEP3 may be deposited by the same process and may be cut and separated by the tips of the second bank BNK2. Accordingly, the third electrode pattern CEP3 may be disposed on the third organic pattern ELP3, in the areas other than the first, second, and third emission areas EA1, EA2, and EA3.

The material for forming the etch control layer ECL may be deposited on the entirety of the surface of the display device 10. The etch control layer ECL may also be disposed on the top surface of the third common electrode CE3, the sides of the first bank BNK1, the bottom surfaces of the tips of the second bank BNK2, and the top surface and sides of the third electrode pattern CEP3. The etch control layer ECL may be formed by an ALD process, but the disclosure is not limited thereto. The etch control layer ECL may be uniformly deposited on the sides of the first bank BNK1 and the bottom surfaces of the tips of the second bank BNK2, via ALD. In an embodiment, the etch control layer ECL may include at least one of IGZO, IZO, and GZO, for example.

The capping layer CAP may also be disposed on the etch control layer ECL, in the third emission area EA3. The capping layer CAP may include an inorganic insulating material and may cover the third light-emitting element ED3. The capping layer CAP may prevent the third light-emitting element ED3 from being damaged by external air.

An inorganic material for forming the capping layer CAP and a third capping pattern CLP3 may be deposited on the entirety of the surface of the display device 10. The third capping pattern CLP3 may include the same inorganic material as that of the capping layer CAP and may be disposed on the etch control layer ECL. The third capping pattern CLP3 may cover the sides of the third electrode pattern CEP3 around the third emission area EA3. The capping layer CAP and the third capping pattern CLP3 may be deposited by the same process and may be cut and separated by the tips of the second bank BNK2. Accordingly, the third capping pattern CLP3 may be disposed on the third electrode pattern CEP3, in the areas other than the first, second, and third emission areas EA1, EA2, and EA3.

An inorganic material for forming a third inorganic layer TL3 may be deposited on the entirety of the surface of the display device 10. The third inorganic layer TL3 may be disposed on the top surface of the capping layer CAP, the sides of the etch control layer ECL, and the top surface and sides of the third capping pattern CLP3. The third inorganic layer TL3 may include an inorganic material and may prevent oxygen or moisture from penetrating the third light-emitting element ED3. The third inorganic layer TL3 may be an inorganic encapsulation layer. In an embodiment, the third inorganic layer TL3 may include or consist of one of the aforementioned example materials for forming the first inorganic layer TL1, for example.

The photoresist PR may also be disposed on the third inorganic layer TL3, in the third emission area EA3. The photoresist PR may be provided on the third inorganic layer TL3, in areas other than the first and second emission areas EA1 and EA2, and may be used as a mask during an etching process.

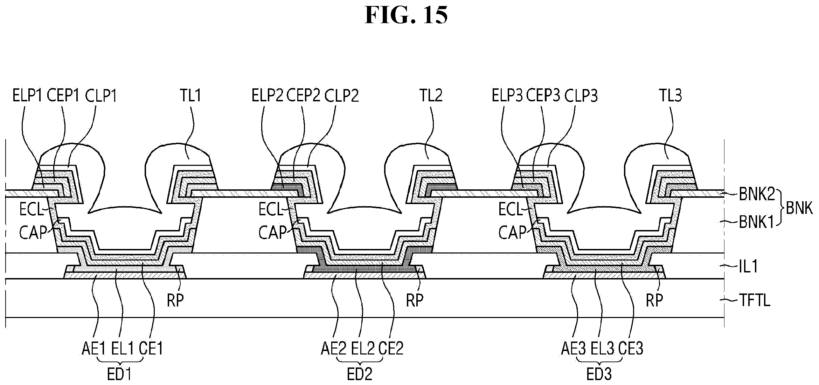

Referring to FIG. 15, parts of the third inorganic layer TL3 and the third capping pattern CLP3 that are not covered by the photoresist PR may be etched by an etching process. In an embodiment, the third inorganic layer TL3 and the third capping pattern CLP3 may be etched by a dry etching process using the F-based etching gas, for example.

Parts of the etch control layer ECL, the third electrode pattern CEP3, and the third organic pattern ELP3 that are not covered by the photoresist PR may be etched by an etching process. In an embodiment, the etch control layer ECL, the third electrode pattern CEP3, and the third organic pattern ELP3 may be etched by a wet etching process, for example, but the disclosure is not limited thereto.

Thereafter, the photoresist PR may be removed by a strip process.

The etch control layer ECL may protect the tips of the second bank BNK2 during the etching of the first and second inorganic layers TL1 and TL2. As the display device 10 includes the etch control layer ECL, the tips of the second bank BNK2 may be prevented from being damaged or bent, and the first, second, and third light-emitting layers EL1, EL2, and EL3 and the first, second, and third common electrodes CE1, CE2, and CE3 may be uniformly formed. Also, the first, second, and third light-emitting elements ED1, ED2, and ED3 may be uniformly formed, and the reliability of the display device 10 may be secured.

Embodiments of the disclosure should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. A display device comprising:
a substrate;
a first pixel electrode disposed in a first emission area on the substrate;
an insulating layer covering edges of the first pixel electrode;
a first light-emitting layer disposed on the first pixel electrode and the insulating layer;
a first common electrode disposed on the first light-emitting layer;
a first bank disposed on the insulating layer and surrounding the first emission area;
a second bank disposed on the first bank and around the first emission area, the second bank including:
tips projected from sides of the first bank; and
an etch control layer disposed on a top surface of the first common electrode, on the sides of the first bank, and on bottom surfaces of the tips of the second bank.

2. The display device of claim 1, further comprising:
a first organic pattern disposed on the second bank, the first organic pattern surrounding the first emission area and including a same material as a material of the first light-emitting layer; and
a first electrode pattern disposed on the first organic pattern, the first electrode pattern including a same material as a material of the first common electrode.

3. The display device of claim 2, wherein the etch control layer is disposed on a top surface and sides of the first electrode pattern.

4. The display device of claim 2 or claim 3, further comprising:
a capping layer disposed on the etch control layer, in the first emission area; and
a first capping pattern disposed on a part of the etch control layer covering the first electrode pattern, the first capping pattern including a same material as a material of the capping layer.

5. The display device of claim 4, further comprising a first inorganic layer disposed in the first emission area, on a top surface of the capping layer, on sides of the etch control layer, and on a top surface and sides of the first capping pattern, optionally wherein a vaporization temperature of the etch control layer for a fluorine-based etching gas is higher than a vaporization temperature of the first inorganic layer for the fluorine-based etching gas.

6. The display device of any one of claims 1 to 5, wherein the etch control layer includes at least one of indium gallium zinc oxide, indium zinc oxide, and gallium zinc oxide.

7. The display device of any one of claims 1 to 6, further comprising:
a second pixel electrode disposed in a second emission area and on the substrate;
a second light-emitting layer disposed on the second pixel electrode; and
a second common electrode disposed on the second light-emitting layer, optionally wherein
the first bank surrounds the second emission area,
the second bank is disposed on the first bank and around the second emission area, and
the etch control layer is disposed on a top surface of the second common electrode, on sides of part of the first bank surrounding the second emission area, and on bottom surfaces of the tips of the second bank around the second emission area.

8. The display device of claim 7, further comprising:
a second organic pattern surrounding the second emission area, on the second bank, the second organic pattern including a same material as a material of the second light-emitting layer; and
a second electrode pattern disposed on the second organic pattern, the second electrode pattern including a same material as a material of the second common electrode.

9. The display device of claim 8, wherein the etch control layer is disposed on a top surface and sides of the second electrode pattern.

10. The display device of claim 8 or claim 9, further comprising:
a capping layer disposed on the etch control layer, in the second emission area; and
a second capping pattern disposed on a part of the etch control layer covering the second electrode pattern, the second capping pattern including a same material as a material of the capping layer, optionally wherein the display device further comprises a second inorganic layer disposed in the second emission area, on a top surface of the capping layer, on sides of the etch control layer, and on a top surface and sides of the second capping pattern.

11. The display device according to claim 1, further comprising:
a capping layer disposed on the etch control layer, in the first emission area, optionally wherein the display device further comprises:
a first organic pattern disposed on the second bank, the first organic pattern surrounding the first emission area and including a same material as a material of the first light-emitting layer; and
a first electrode pattern disposed on the first organic pattern, the first electrode pattern including a same material as a material of the first common electrode,
wherein the etch control layer is disposed on a top surface and sides of the first electrode pattern.

12. A method of manufacturing a display device, comprising:
forming first and second pixel electrodes on a substrate;
sequentially stacking a sacrificial layer, an insulating layer, a first bank, and a second bank on the first and second pixel electrodes;
forming tips of the second bank, the tips protruding from sides of the first bank, by etching the second bank and the first bank;
exposing the first and second pixel electrodes by etching the insulating layer and the sacrificial layer;
forming a first light-emitting layer on the first pixel electrode and forming a first organic pattern on the second bank;
forming a first common electrode on the first light-emitting layer and forming a first electrode pattern on the first organic pattern; and
forming an etch control layer disposed on a top surface of the first common electrode, on the sides of the first bank, on bottom surfaces of the tips of the second bank, and on a top surface and sides of the first electrode pattern.

13. The method of claim 12, further comprising:
forming a capping layer on a part of the etch control layer covering the first common electrode and forming a first capping pattern on a part of the etch control layer covering the first electrode pattern; and
forming a first inorganic layer disposed on a top surface of the capping layer, on sides of the etch control layer, and on a top surface and sides of the first capping pattern.

14. The method of claim 13, further comprising:
forming photoresist disposed on the first inorganic layer, in a first emission area; and
etching the first inorganic layer, the first capping pattern, and the capping layer using the photoresist as a mask.

15. The method of claim 14, wherein:
(i) the etching the first inorganic layer, the first capping pattern, and the capping layer, comprises preventing the tips of the second bank from being etched by the etch control layer; and/or
(ii) the etching the first inorganic layer, the first capping pattern, and the capping layer, comprises performing a dry etching process using a fluorine-based etching gas.
